# EUROPEAN PATENT APPLICATION

(11) **EP 4 757 506 A1**
(43) Date of publication of application: **10.06.2026**
(21) Application number: 25857952.3
(22) Date of filing: 04.08.2025
(51) Int. Cl.: H05K 1/14

(54) **CIRCUIT BOARD ASSEMBLY AND ELECTRONIC DEVICE**

(30) Priority: 05.09.2024 CN 202411237220
(71) Applicant: Honor Device Co., Ltd., Shenzhen, Guangdong 518040 (CN)
(72) Inventor: GUO, Jianqiang, Shenzhen, Guangdong 518040 (CN)
(74) Representative: MERH-IP Matias Erny Reichl Hoffmann Patentanwälte PartG mbB
(86) International application number: PCT/CN2025/112409
(87) International publication number: WO 2026/051662

(57) **Abstract**

This application relates to the field of electronic device technologies, and in particular, to a circuit board assembly and an electronic device. The circuit board assembly includes a circuit board, an electrical connection board, and a flexible circuit board. The electrical connection board is mounted on the circuit board in a thickness direction of the circuit board assembly, and is electrically connected to the circuit board. At least a part of the flexible circuit board has a flexible structure. The flexible circuit board includes a first connection segment and a second connection segment. The first connection segment is configured to connect to a component of an electronic device. The second connection segment is connected to the electrical connection board. The electrical connection board is configured to adjust a distance between the second connection segment and the circuit board in the thickness direction of the circuit board assembly, to adjust a bent form of the flexible circuit board without changing a distance between the component of the electronic device and the circuit board in a width direction of the electronic device.

## Description

This application claims priority to Chinese Patent Application No. 2024112372206, filed with the China National Intellectual Property Administration on September 5, 2024 and entitled "CIRCUIT BOARD ASSEMBLY AND ELECTRONIC DEVICE", which is incorporated herein by reference in its entirety.

### TECHNICAL FIELD

This application relates to the field of electronic device technologies, and in particular, to a circuit board assembly and an electronic device.

### BACKGROUND

In various states such as modem life and working communication, electronic devices such as smart watches, mobile phones, and notebook computers gradually become the necessities in the life of modern people. A mobile phone is used as an example of an electronic device, and includes a battery, a mainboard, a screen assembly, and a casing. The battery, the mainboard, and the screen assembly are disposed within the casing. The mainboard includes a circuit board and electronic elements disposed on the circuit board. The electronic elements include, but not limited to, a processor and an antenna module.

As electronic devices incorporate increasingly diverse functions, more and more components are also arranged inside the electronic devices. Being bendable, a flexible circuit board may be configured for electrically connecting a component and a circuit board. However, when the bent form of the flexible circuit board is poor, excessively bending of the flexible circuit board or friction with parts nearby is caused, affecting the service life.

### SUMMARY

Embodiments of this application provide a circuit board assembly and an electronic device, to satisfy a proper bent form of a flexible circuit board.

Embodiments of this application provide a circuit board assembly, used in an electronic device. The circuit board assembly includes:
a circuit board;
an electrical connection board, where the electrical connection board is mounted on the circuit board in a thickness direction of the circuit board assembly, and is electrically connected to the circuit board; and
a flexible circuit board, where at least a part of the flexible circuit board has a flexible structure, the flexible circuit board includes a first connection segment and a second connection segment, the first connection segment is configured to connect to a component of the electronic device, the second connection segment is connected to the electrical connection board, and the electrical connection board is configured to adjust a distance between the second connection segment and the circuit board in the thickness direction of the circuit board assembly.

In the embodiments of this application, the placement of the electrical connection board between the second connection segment of the flexible circuit board and the circuit board in a thickness direction of the electronic device can help adjust a distance between a second connection board and the circuit board in the thickness direction of the electronic device, so that a height difference between two ends of the flexible circuit board can be adjusted without changing a distance between the component of the electronic device and the circuit board in a width direction of the electronic device, thereby providing the flexible circuit board with a proper bent form and prolonging the service life.

In a possible design, the circuit board is provided with a recessed structure recessed in the thickness direction of the circuit board assembly; and
a partial structure of the electrical connection board is accommodated in the recessed structure, and the electrical connection board and the recessed structure are configured for adjusting the distance between the second connection segment and the circuit board in the thickness direction of the circuit board assembly.

In the embodiments of this application, the recessed structure is provided in the circuit board, and the range within which the height difference between the two ends of the flexible circuit board can be adjusted is increased through the cooperation between the electrical connection board and the recessed structure.

In a possible design, the recessed structure includes at least one groove.

In the embodiments of this application, the groove is provided in the circuit board, the depth of the groove may be adjusted based on an actual depth. A partial structure of the electrical connection board is disposed in the groove, and the depth of the groove may be adjusted based on a required height difference between the two ends of the flexible circuit board, so that the height difference between the two ends of the flexible circuit board is proper, and the flexible circuit board obtains a better form.

In addition, the number of electrical connection boards may be properly increased, and the range of the height difference between the two ends of the flexible circuit board may be increased.

In a possible design, the recessed structure includes a first groove and a second groove that are spaced apart, and the circuit board is further provided with an element placement area located between the first groove and the second groove;
the electrical connection board includes a first board, a second board, and a third board, a partial structure of the first board is accommodated in the first groove, a partial structure of the second board is accommodated in the second groove, the third board is disposed on the first board and the second board, and is electrically connected to the first board and the second board, and the third board is further electrically connected to the second connection segment; and
a gap exists between the third board and the element placement area in the thickness direction of the circuit board assembly.

In the embodiments of this application, elements need to be arranged in the element placement area of the circuit board. To avoid the elements arranged on the circuit board, groove structures are provided in areas on two sides of the element placement area of the circuit board, thereby implementing element arrangement while satisfying the matching of any height difference of the flexible circuit board.

In a possible design, when a depth of the first groove is greater than a thickness of the first board and a depth of the second groove is greater than a thickness of the second board, the third board is provided with a clearance groove for avoiding the element placement area.

In the embodiments of this application, the third board is provided with the clearance groove to avoid interference between the third board and the element placement area, thereby ensuring that the third board is electrically connected to the first board and the second board, and ensuring that the cooperation between the electrical connection board and the circuit board can satisfy a height difference required by the flexible circuit board.

In a possible design, the recessed structure is a through hole penetrating the circuit board in a thickness direction of the circuit board.

In the embodiments of this application, a through hole structure is provided in the circuit board, so that the depth of the recessed structure in the circuit board can be further increased, and a partial structure of the electrical connection board is disposed in the through hole to adjust the range of the height difference between the two ends of the flexible circuit board, so that the height difference between the two ends of the flexible circuit board is proper, thereby providing the flexible circuit board with a better form.

In a possible design, the recessed structure includes a first hole, the electrical connection board includes a first board and a second board, and the first board is connected to the circuit board and seals the first hole from a bottom; and
one end of the second board is connected to the first board, and the other end of the second board extends out of the through hole and is electrically connected to the second connection segment.

In the embodiments of this application, after the first hole is provided in the circuit board, the first board is disposed at the bottom to seal the first hole, and the second board located in the first hole is supported, thereby ensuring the operating stability of the circuit board assembly.

In a possible design, the recessed structure includes a first hole and a second hole, and the circuit board is further provided with an element placement area located between the first hole and the second hole;
the electrical connection board includes a first board, a second board, a third board, and a fourth board, the first board and the fourth board are distributed in the thickness direction of the circuit board assembly, and the second board and the third board are located between the first board and the fourth board and are connected to the first board and the fourth board; and
the first board is connected to the circuit board and seals the first hole and the second hole from a bottom, a partial structure of the second board is located in the first hole, a partial structure of the third board is located in the second hole, the fourth board is electrically connected to the second connection segment, and a gap exists between the fourth board and the element placement area in the thickness direction of the circuit board assembly.

In the embodiments of this application, elements need to be arranged in the element placement area of the circuit board. To avoid the elements arranged on the circuit board, hole structures are provided in areas on the two sides of the element placement area of the circuit board, thereby implementing element arrangement while satisfying the matching of any height difference of the flexible circuit board.

In a possible design, the electrical connection board is a PCB board; or
the electrical connection board includes a conductive portion and a cladding portion, the conductive portion is located in the cladding portion, two ends of the conductive portion in the thickness direction of the circuit board assembly are exposed from the cladding portion, and the electrical connection board is electrically connected to the circuit board and the second connection segment by the conductive portion.

In the embodiments of this application, the electrical connection board may be made of a conductor, that is, each position of the electrical connection board can conduct electricity. For example, the electrical connection board may be an original printed circuit board of the electronic device, and the electrical connection board can be configured for arranging elements of the electronic device in addition to being configured for height matching.

The electrical connection board may alternatively be a manufactured structure. That is, a partial structure of the electrical connection board can be electrically conductive, and a partial structure of the electrical connection board is electrically isolating.

In a possible design, the flexible circuit board includes a deformation segment, and the deformation segment is located between the first connection segment and the second connection segment and is connected to the first connection segment and the second connection segment; and
the first connection segment and the second connection segment are rigid materials.

In the embodiments of this application, the deformation segment is configured for generating a bent form, and the deformation segment is a flexible material. The first connection segment and the second connection segment are configured to connect to another component or a circuit board, and the first connection segment and the second connection segment are made of a rigid material.

Alternatively, the flexible circuit board may be made of a flexible material.

In a possible design, after the deformation segment is bent, a radius of an arc-shaped bend formed at an end of the deformation segment close to the first connection segment is a first radius R1, and a radius of an arc-shaped bend formed at an end of the deformation segment close to the second connection segment is a second radius R2; and
when R1 ≤ 0.6 mm, and/or, R2 ≤ 0.6 mm, a copper material in the flexible circuit board is HA copper.

In the embodiments of this application, HA copper has an excellent bending characteristic. When R1 ≤ 0.6 mm, and/or, R2 ≤ 0.6 mm, HA copper may be used for copper in the deformation segment 54f to prevent a bending angle at two ends of the deformation segment 54f from being excessively small and consequently avoid fracturing at the two ends of the deformation segment 54f.

In a possible design, a minimum distance between the first connection segment and the second connection segment is D1 ≥ 2 mm.

In the embodiments of this application, the minimum distance between the first connection segment and the second connection segment is defined to ensure that the deformation segment has a proper bent form.

In a possible design, a minimum distance between a conductive hole in the first connection segment and the deformation segment is D2 > 0.5 mm; and
a minimum distance between a conductive hole in the second connection segment and the deformation segment is D2 > 0.5 mm.

In the embodiments of this application, the minimum distances between the conductive holes in the first connection segment and the second connection segment and the deformation segment are defined to prevent guide holes from being electrically connected to the deformation segments, causing an abnormality in the circuit.

In a possible design, a minimum distance between a circuit on the first connection segment and a connection position between the first connection segment and the deformation segment is D3 > 0.25 mm; and
a minimum distance between a circuit on the second connection segment and a connection position between the second connection segment and the deformation segment is D4 > 0.25 mm.

In the embodiments of this application, a distance exists between the circuit on the first connection segment and the deformation segment is defined to avoid bending of the circuit on the first connection segment in a process of bending the deformation segment. A distance exists between the circuit on the second connection segment and the deformation segment is defined to avoid bending of the circuit on the second connection segment in a process of bending the deformation segment.

In a possible design, in an arrangement direction of the component of the electronic device and the electrical connection board, a ramp angle C of the flexible circuit board satisfies 0° ≤ C ≤ 80°.

In the embodiments of this application, the height difference between the two ends of the flexible circuit board and a width distance between the two ends are defined, so that the ramp angle of the flexible circuit board can be defined from 0° to 80° to ensure that the flexible circuit board forms a proper bent form, thereby reducing the risk of damage to the flexible circuit board.

Embodiments of this application further provide an electronic device. The electronic device includes the foregoing circuit board assembly.

In a possible design, the electronic device includes a mainboard and a camera module, the camera module includes a lens, a lens holder, and a sensor, the sensor is connected to a bottom of the lens holder, the mainboard is a circuit board of the circuit board assembly, the first connection segment of the flexible circuit board is electrically connected to the sensor, and the second connection segment of the flexible circuit board is electrically connected to the electrical connection board by a connector.

In the embodiments of this application, because the circuit board assembly is applied to a camera scenario, the camera module and the mainboard are disposed at different heights. The cooperation of the electrical connection board and the recessed structure can help adjust a distance between the second connection segment of the flexible circuit board and the sensor in the thickness direction of the electronic device, so that the bent form of the flexible circuit board can be adjusted without changing a distance between the circuit board and the sensor in the width direction of the electronic device.

The flexible circuit board may be connected to a corresponding component or the electrical connection board through soldering. Alternatively, the flexible circuit board may be connected to a corresponding component or the electrical connection board by a connector.

In a possible design, the electronic device includes a mainboard, a charging module, and a sub-board, the charging module includes a battery, the mainboard and the sub-board are circuit boards of the circuit board assembly, the first connection segment of the flexible circuit board is connected to the battery, and the second connection segment of the flexible circuit board is connected to the electrical connection board by a connector.

In the embodiments of this application, the circuit board assembly is applied to a charging scenario. The electronic device may be a bar-type phone, a dual-fold phone, a tri-fold phone, a quad-fold phone, or the like. The charging scenario may involve a plurality of flexible circuit boards, and some structures connecting each flexible circuit board to a corresponding component or the mainboard/sub-board may have a bent shape. To improve the bent form of each flexible circuit board and reduce the risk of fracturing of each flexible circuit board, the height difference between the two ends of the flexible circuit board may be adjusted through the mutual cooperation of the electrical connection board and the recessed structure, so that the flexible circuit board has a proper bent form.

The flexible circuit board may be connected to a corresponding component or the electrical connection board through soldering. Alternatively, the flexible circuit board may be connected to a corresponding component or the electrical connection board by a connector.

### BRIEF DESCRIPTION OF DRAWINGS

FIG. 1 is a schematic diagram of a structure of an electronic device in an embodiment;
FIG. 2 is a schematic exploded view of an electronic device;
FIG. 3 is a schematic diagram of a system on a chip;
FIG. 4 is a cross-sectional view of an electronic device at a camera module;
FIG. 5 is a schematic diagram of a mounting board (mainboard);
FIG. 6 is a schematic diagram of a structure of a camera module;
FIG. 7 is a schematic exploded view of FIG. 6;
FIG. 8 is a schematic diagram of data connection and transmission between a camera module and a system on a chip;
FIG. 9 is a schematic diagram of a connector;
FIG. 10 is a schematic cross-sectional view of a camera module being electrically connected to a mainboard in an embodiment;
FIG. 11 is a schematic enlarged view of a partial structure in FIG. 10;
FIG. 12 is a schematic cross-sectional view of a camera module being electrically connected to a mainboard in another embodiment;
FIG. 13 is a schematic diagram of a circuit board assembly in an embodiment according to this application;
FIG. 14 is a schematic diagram of a circuit board assembly in another embodiment according to this application;
FIG. 15 is a schematic diagram of a circuit board assembly in another embodiment according to this application;
FIG. 16 is a schematic diagram of a circuit board assembly in another embodiment according to this application;
FIG. 17 is a schematic diagram of a mainboard in an embodiment according to this application;
FIG. 18 is a schematic diagram of a circuit board assembly in another embodiment according to this application;
FIG. 19 is a schematic diagram of an electrical connection board in an embodiment according to this application;
FIG. 20 is a schematic diagram of a circuit board assembly in another embodiment according to this application;
FIG. 21 is a schematic diagram of a circuit board assembly in another embodiment according to this application;
FIG. 22 is a schematic diagram of a circuit board assembly in another embodiment according to this application;
FIG. 23 is a schematic diagram of a mainboard in another embodiment according to this application;
FIG. 24 is a schematic diagram of a circuit board assembly in another embodiment according to this application;
FIG. 25 is a schematic diagram of an electrical connection board in an embodiment according to this application;
FIG. 26 is a schematic diagram of an electrical connection board in another embodiment according to this application;
FIG. 27 is a schematic diagram of an electrical connection board in another embodiment according to this application;
FIG. 28 is a layout diagram of pads on the electrical connection board in FIG. 27;
FIG. 29 is a schematic diagram of a circuit board assembly in another embodiment according to this application;
FIG. 30 is a schematic diagram of adapting two camera modules with two flexible circuit boards when the two camera modules are disposed in an electronic device;
FIG. 31 is a schematic diagram of a structure of the two flexible circuit boards in FIG. 30;
FIG. 32 is a schematic flowchart of a soldering in the embodiment shown in FIG. 14;
FIG. 33 is a schematic diagram of a flexible circuit board in an embodiment according to this application;
FIG. 34 is a schematic cross-sectional view of the flexible circuit board in FIG. 33;
FIG. 35 is a schematic diagram of a flexible circuit board in another embodiment according to this application;
FIG. 36 is a schematic cross-sectional view of the flexible circuit board in FIG. 34;
FIG. 37 is a schematic diagram of an electronic device in a charging scenario in an embodiment;
FIG. 38 is a schematic diagram of an electronic device in a charging scenario in another embodiment;
FIG. 39 is a schematic diagram of an electronic device in a charging scenario in another embodiment;
FIG. 40 is a schematic diagram of an electronic device in a charging scenario in another embodiment; and
FIG. 41 is a schematic diagram of an electronic device in a charging scenario in another embodiment.

### Reference numerals:

100-electronic device, 10a-housing, 10b-display, 10c-circuit board assembly, 1c-mainboard, 11c-groove, 12c-first groove, 13c-second groove, 14c-element placement area, 15c-through hole, 16c-first hole, 17c-second hole, 2c-electrical connection board, 21c-first board, 22c-second board, 23c-third board, 231c-clearance groove, 24c-fourth board, 25c-first pad, 26c-conductive portion, 27c-cladding portion, 10d-mid-frame assembly, 10e-key module, 10f-camera module, 101f-first camera module, 102f-second camera module, 1f-lens, 2f-lens holder, 3f-filter, 4f-sensor, 5f-flexible circuit board, 51f-first flexible circuit board, 511f-first connection end, 512f-second connection end, 513f-first bending segment, 52f-second flexible circuit board, 521f-third connection end, 522f-fourth connection end, 523f-second bending segment, 53f-reinforcing board, 54f-deformation segment, 55f-first connection segment, 551f-second pad, 552f-conductive hole, 56f-second connection segment, 57f-third pad, 6f-connector, 61f-male end, 62f-female end, 10g-battery, 10h-wireless charging coil, 10i-microphone, 10j-fingerprint module, 10k-card tray, 10l-motor, 10m-system on a chip, and 10n-mounting board;
1-sub-board, 1a-charging port, 2-first battery, 3-first connector, 4-second connector, 5-third connector, 6-charging flexible circuit board, 7-first battery flexible circuit board, 8-first folding section, 9-second folding section, 10-first rotating shaft, 11-first hinge flexible circuit board, 12-fourth connector, 13-fifth connector, 15-first sub-mainboard, 16-sixth connector, 17-second battery, 18-second battery flexible circuit board, 19-third folding section, 20-second rotating shaft, 21-second sub-mainboard, 22-second hinge flexible circuit board, 23-seventh connector, 24-eighth connector, 25-third battery, 26-third battery flexible circuit board, 27-ninth connector, 28-three-way flexible circuit board, 29-fourth folding section, 30-third rotating shaft, 31-third sub-mainboard, 32-third hinge flexible circuit board, 33-tenth connector, 34-eleventh connector, 35-fourth battery, 36-fourth battery flexible circuit board, and 37-twelfth connector; and
X-width direction, Y-length direction, and Z-thickness direction.

### DESCRIPTION OF EMBODIMENTS

In a specific embodiment, this application is further described in detail below with reference to specific embodiments and the accompanying drawings.

A circuit board assembly provided in embodiments of this application may be used in an electronic device. The electronic device may include, but is not limited to, a mobile or fixed terminal, for example, a mobile phone, a tablet computer, or a notebook computer. For ease of description, a mobile phone is used as an example to describe the embodiments of this application.

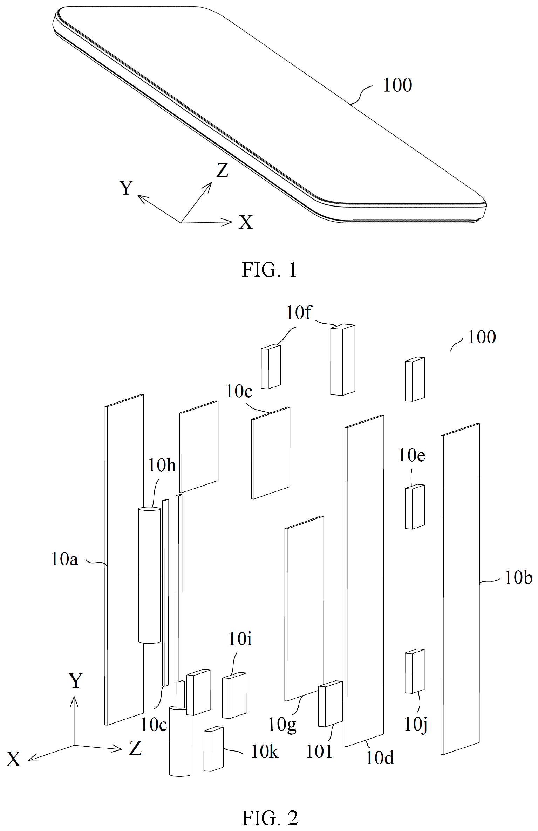

As a schematic diagram of a structure of an electronic device shown in FIG. 1, an X direction, a Y direction, and a Z direction are shown in the figure. It is defined below that a thickness direction of the electronic device 100 is the Z direction, a width direction of the electronic device is the X direction, and a length direction of the electronic device is the Y direction.

FIG. 2 is a schematic exploded view of a structure of the electronic device 100 in a specific embodiment. The electronic device 100 may include a housing 10a, a display 10b, and a mid-frame assembly 10d. The housing 10a and the display 10b together enclose an accommodating space (not shown in the figure). The mid-frame assembly 10d is located between the housing 10a and the display 10b.

The electronic device 100 further includes parts such as a circuit board assembly 10c, a key module 10e, a camera module 10f, a battery 10g, a wireless charging coil 10h, a microphone 10i, a fingerprint module 10j, a card tray 10k, and a motor 10l. The components such as the circuit board assembly 10c, the key module 10e, the camera module 10f, the battery 10g, the wireless charging coil 10h, the microphone 10i, the fingerprint module 10j, the card tray 10k, and the motor 101 are located in the accommodating space, and are mounted on the mid-frame assembly 10d. The mid-frame assembly 10d provides support and protection for components inside the electronic device 100.

A person skilled in the art may understand that the schematic structure in the embodiments of this application constitutes no specific limitation on the electronic device. In some other implementations of this application, the electronic device may include more or fewer parts than those shown in the figure, or some parts may be combined, or some parts may be split, or different part arrangements may be used.

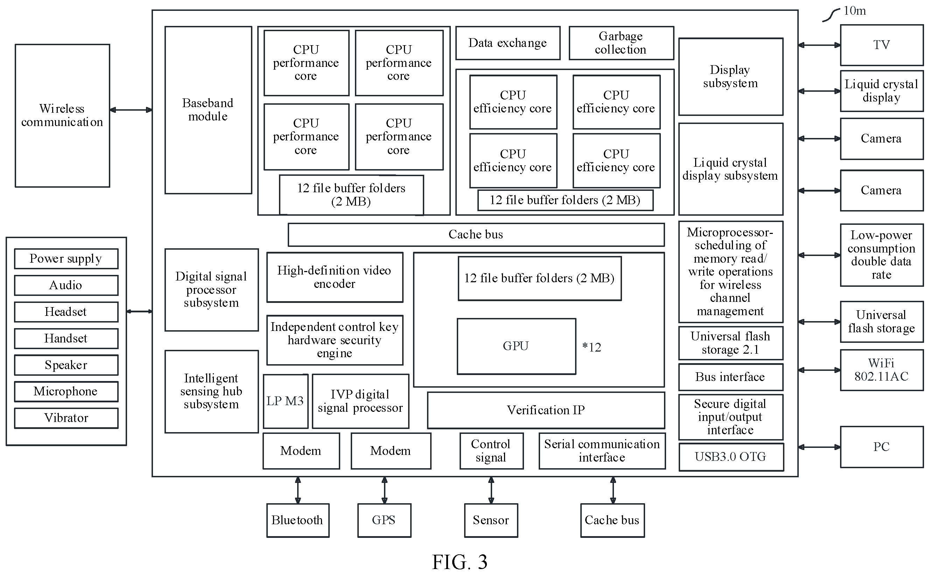

FIG. 3 is a schematic diagram of a system on a chip 10m. The electronic device 100 is connected to components by the system on a chip 10m. The system on a chip 10m is a chip integrating a plurality of circuits, and is the core of the entire electronic device 100. The system on a chip 10m includes a plurality of interfaces. The plurality of interfaces are configured to connect to a plurality of functional modules such as a CPU, a communication module, Wi-Fi, an audio processing module, an image processing module, a camera module 10f, a memory, Bluetooth, and a GPS.

Because the electronic device 100 needs to incorporate increasingly diverse functions, more and more components are also arranged inside the electronic device 100. Some components are stacked inside the electronic device 100 in the thickness direction Z.

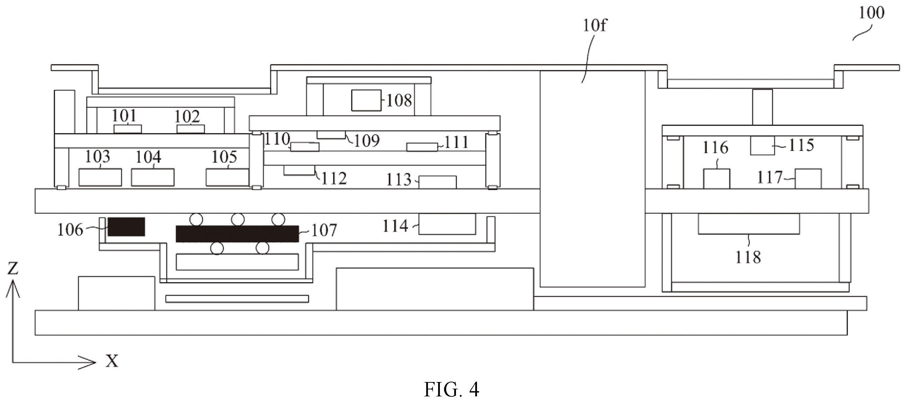

FIG. 4 is a cross-sectional view of the electronic device 100 at the camera module 10f. The camera module 10f and a plurality of components disposed near the camera module 10f are included. Black blocks in the figure represent components (101 to 118). The components (101 to 118) are mounted on a corresponding circuit board. The components (101 to 118) may be a resistor, a capacitor, an inductor, a radio frequency chip, a sensor, Bluetooth, a GPS, and the like. As can be seen from the figure, to maximally use limited space inside the electronic device 100, some components (101 to 118) are stacked, and may be specifically stacked in three layers, four layers, five layers, or even six layers.

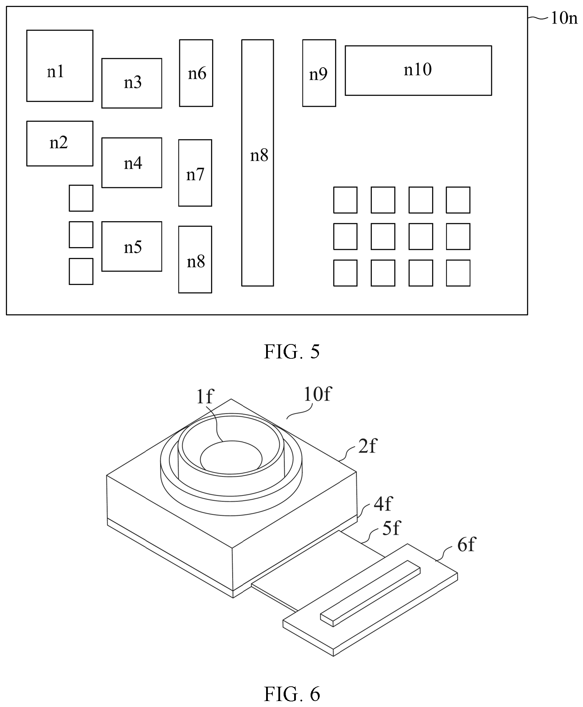

FIG. 5 is a schematic diagram of a mounting board 10n (for example, a mainboard). Most chips (for example, n1 to n10) in the electronic device are integrally mounted on the mounting board 10n (for example, the mainboard). Referring to FIG. 4 and FIG. 5 together, the foregoing components need to be electrically connected to the mounting board 10n (for example, the mainboard), to implement electrical connection to corresponding chips. Because internal space of the electronic device is limited, some components in the electronic device may be displaced with respect to the mounting board 10n (for example, the mainboard). Therefore, a flexible circuit board having a bent form is required to connect the components to the mounting board 10n (for example, the mainboard). It should be noted that the mounting board 10n may alternatively be another circuit board, for example, a sub-mainboard.

An example in which the camera module is electrically connected to the mainboard is used for description below.

FIG. 6 is a schematic diagram of a structure of a camera module 10f in a specific embodiment. As shown in FIG. 6, the camera module 10f includes a lens 1f, a lens holder 2f, a sensor 4f, a flexible circuit board 5f, and a connector 6f. The lens 1f and the sensor 4f are mounted in the lens holder 2f. One end of the flexible circuit board 5f is connected to the sensor 4f, and the other end of the flexible circuit board 5f is electrically connected to the connector 6f. The connector 6f is configured to electrically connect to the mainboard.

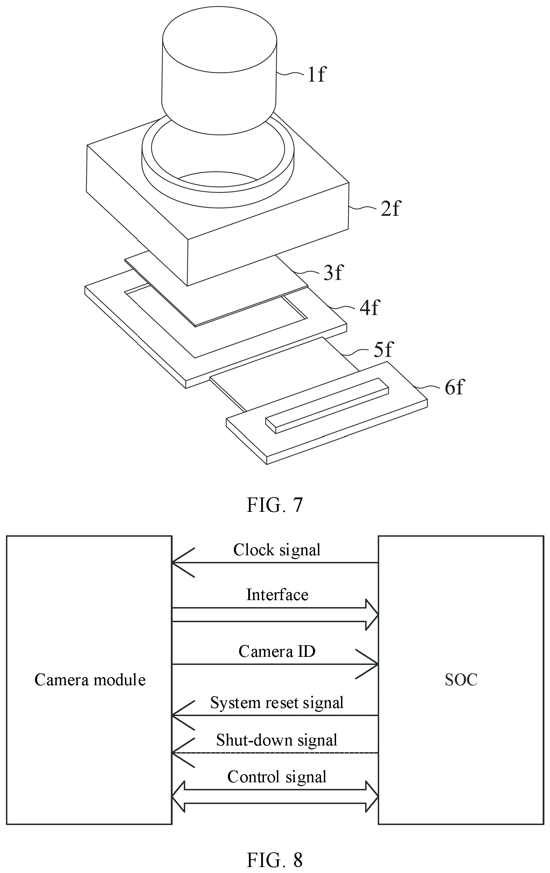

FIG. 7 is a schematic exploded view of the camera module 10f. Referring to FIG. 7 and with reference to FIG. 6, the camera module 10f further includes a filter 3f. The lens 1f, the filter 3f, and the sensor 4f are mounted in the lens holder 2f. The filter 3f is located between the lens 1f and the sensor 4f, and is configured to filter out ultraviolet light and infrared light that cannot be observed by human eyes. A generated optical image of a photographed object is projected to the sensor 4f through the lens 1f. The optical image is converted into a digital signal, and then the digital signal is sent to the system on a chip on the mainboard for processing. Finally, the digital signal is converted into an image that can be seen on the screen of the electronic device.

In the embodiments shown in FIG. 6 and FIG. 7, the camera module 10f is in an unmounted state. Because the sensor 4f and the connector 6f are located at the same height, the flexible circuit board 5f connecting the sensor 4f and the connector 6f has a flat panel shape without bending.

Specifically, FIG. 8 is a schematic diagram of data connection and transmission between a camera module and a system on a chip. A Mobile Industry Processor Interface (Mobile Industry Processor Interface, MIPI for short) needs to be configured for transmission between the camera module and the system on a chip to support transmission of a large size of data and ensure image quality and transmission efficiency. Data transmitted between the camera module and the system on a chip includes a clock signal (Master clock for sensor logical chip, MCLK for short), a camera ID (camera ID, CAM ID for short), a system reset signal (RESET), a shut-down signal (SHDN), a control signal (12C), and the like.

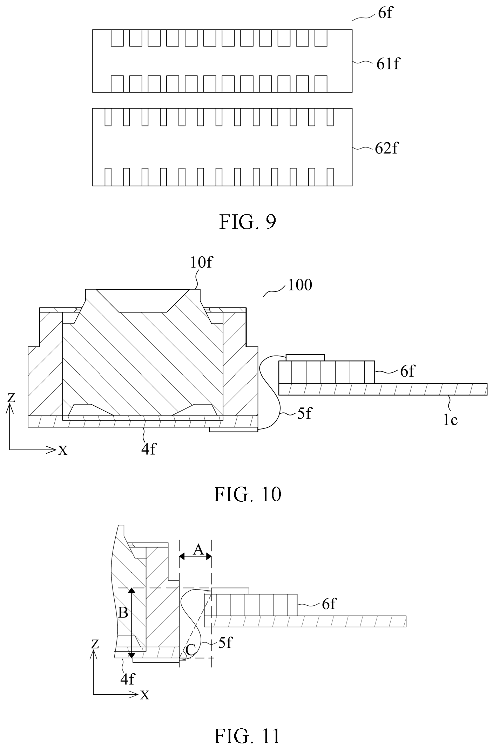

The connector 6f may be a board-to-board connector. As shown in FIG. 9, the connector 6f has a male end 61f and a female end 62f. The male end 61f is configured to be fixed to the mainboard. The female end 62f is configured to be connected to the flexible circuit board. The male end 61f and the female end 62f mate with each other to electrically connect the flexible circuit board to the mainboard, thereby electrically connecting the camera module to the system on a chip SOC on the mainboard.

FIG. 10 is a schematic cross-sectional view of electrical connection between the camera module 10f and a mainboard 1c in a specific embodiment. The electronic device 100 includes the camera module 10f, the flexible circuit board 5f, the connector 6f, and the mainboard 1c. The sensor 4f of the camera module 10f is electrically connected to one end of the flexible circuit board 5f, the other end of the flexible circuit board 5f is connected to the connector 6f, and the connector 6f is electrically connected to the mainboard 1c, so that the sensor 4f is electrically connected to the mainboard 1c. Two ends of the flexible circuit board 5f are respectively connected to the sensor 4f and the connector 6f. Because the camera module 10f has an increasingly large size, a partial structure of the camera module 10f is usually located below the mainboard 1c, so that a partial structure of the camera module 10f is located below the connector 6f, and the sensor 4f is located at the bottom of the camera module 10f. Therefore, the sensor 4f is located below the connector 6f in some cases, that is, the heights of the sensor 4f and the connector 6f are different in the thickness direction Z of the electronic device 100, so that a height difference is formed between the two ends of the flexible circuit board 5f connecting the sensor 4f and the connector 6f, and the flexible circuit board 5f has a bent form after being mounted.

The length of the flexible circuit board 5f is usually designed to be a fixed length. The length of the flexible circuit board 5f affects the bent form of the flexible circuit board 5f. Usually, when the flexible circuit board 5f has an S-shape or another rounded shape after being bent, the bent form of the flexible circuit board 5f is optimal and is not easily susceptible to fracturing. When a distance between the connector 6f and the sensor 4f in the thickness direction Z of the electronic device 100 is fixed and a distance between the connector 6f and the sensor 4f in the width direction X or the length direction Y of the electronic device 100 is fixed, if the length of the flexible circuit board 5f is excessively large, the bending degree of the flexible circuit board 5f is excessively large, and the flexible circuit board 5f is easily susceptible to damage. If the length of the flexible circuit board 5f is excessively small, the bending degree of the flexible circuit board 5f is excessively small. Consequently, a bending angle easily occurs at positions at which the flexible circuit board 5f is connected to the connector 6f and the sensor 4f. Consequently, the flexible circuit board 5f is easily susceptible to damage.

In some embodiments, the bent form of the flexible circuit board 5f may be adjusted in the following two manners, so that the flexible circuit board 5f is bent into a proper S or another shape, to prevent the flexible circuit board 5f from being excessively bent to cause fracturing. One manner is adjusting the distance between the connector 6f and the sensor in the thickness direction Z of the electronic device. In the other manner, when the camera module 10f and the mainboard 1c are arranged in the width direction X of the electronic device, the distance between the sensor 4f and the connector 6f in the width direction X of the electronic device 100 is adjusted, and when the camera module 10f and the mainboard 1c are arranged in the length direction Y of the electronic device, the distance between the sensor 4f and the connector 6f in the length direction Y of the electronic device is adjusted.

An example in which the mainboard and the camera module are arranged in the width direction of the electronic device is used for description below. For example, when the length of the flexible circuit board is excessively large, the bent form of the flexible circuit board may be adjusted by increasing the distance between the connector and the sensor in the thickness direction of the electronic device, or the bent form of the flexible circuit board may be adjusted by increasing the distance between the connector and the sensor in the width direction of the electronic device. Certainly, the bent form of the flexible circuit board may alternatively be adjusted in another manner, and details are not described in this application again.

The adjustment of the bent form of the flexible circuit board by increasing the distance between the connector and the sensor in the width direction of the electronic device is first described below. Specifically, FIG. 11 is a schematic enlarged view of a partial structure of FIG. 10. The flexible circuit board 5f forms a bent shape after the sensor 4f is connected to the connector 6f of the camera module. Two parameters A and B of the flexible circuit board 5f in the figure need to be controlled to limit a ramp angle (C) of the flexible circuit board 5f, thereby satisfying that the flexible circuit board 5f forms a proper bent form. A position at which the sensor 4f is connected to the flexible circuit board 5f is a first connection position, a position at which the flexible circuit board 5f is connected to the connector 6f is a second connection position, and the ramp angle of the flexible circuit board 5f represents the value of an included angle formed between a connection line between the first connection position and the second connection position and the horizontal plane. For details, refer to Table 1 below.

**Table 1**

| Parameter | Parameter meaning | Relationship between parameters |
|---|---|---|
| A | Distance between the sensor 4f and the connector 6f connected to the flexible circuit board 5f in the width direction X of the electronic device 100 | A ≥ 20% × B |
| B | Distance between the sensor 4f and the connector 6f connected to the flexible circuit board 5f in the thickness direction Z of the electronic device 100 | B ≤ 10 mm |
| C | Ramp angle of the flexible circuit board 5f | Value range: 0° to 80° |

It can be known from Table 1 that in some embodiments, A and B may be limited as B ≤ 10 mm and A ≥ 20% × B. The foregoing limitation is merely a possible embodiment, and does not constitute an absolute limitation to the scope of protection of this application. The height difference (B) between the two ends of the flexible circuit board 5f and the width distance (A) between the two ends are defined, so that the ramp angle of the flexible circuit board 5f can be defined from 0° to 80° to ensure that the flexible circuit board 5f forms a proper bent form, thereby reducing the risk of damage to the flexible circuit board 5f.

Under a high-density space requirement of the electronic device 100, if the distance between the sensor 4f and the connector 6f in the width direction X of the electronic device 100 is increased, positions of nearby components may be occupied, and the width of the electronic device 100 is increased. Consequently, the overall size of the electronic device 100 is increased, leading to increased costs. Therefore, the movement of the sensor 4f and the connector 6f in the width direction X of the electronic device 100 is limited, that is, the distance between the sensor 4f and the connector 6f in the width direction X of the electronic device 100 cannot be further increased.

In addition, referring to FIG. 10, when the distance between the sensor 4f and the connector 6f in the width direction X of the electronic device 100 remains unchanged and the length of the flexible circuit board 5f is a fixed value, if the distance between the sensor 4f and the connector 6f in the thickness direction Z of the electronic device 100 is excessively small, a height difference between the two ends of the flexible circuit board 5f decreases, the bending of the flexible circuit board 5f toward the two sides is excessively large, and contact and wear of the flexible circuit board 5f with parts on the two sides of the flexible circuit board 5f occur easily.

A circuit board assembly provided in embodiments of this application can resolve the foregoing technical problems.

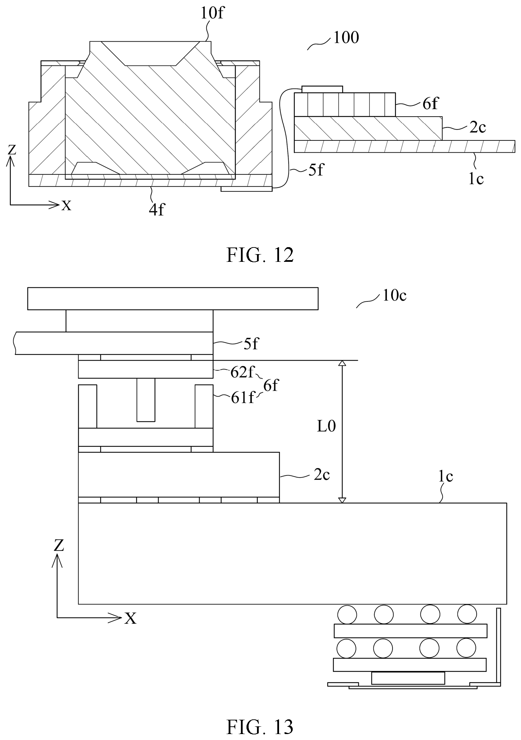

FIG. 12 is a schematic cross-sectional view of electrical connection between the camera module 10f and the mainboard 1c in another specific embodiment. Compared with the embodiment shown in FIG. 10, the electronic device 100 in this embodiment further includes an electrical connection board 2c. The electrical connection board 2c is disposed between the connector 6f and the mainboard 1c in the thickness direction Z of the electronic device 100, and electrically connects the connector 6f to the mainboard 1c. As an auxiliary component, the electrical connection board 2c is located between the connector 6f and the mainboard 1c in the thickness direction of the electronic device.

The electrical connection board 2c can provide an adaptive height for the connector 6f to adjust a height difference of the flexible circuit board 5f in the thickness direction Z of the electronic device 100, so that the flexible circuit board 5f has a proper bent form.

Specifically, FIG. 13 is a schematic diagram of a circuit board assembly in FIG. 12 in an embodiment. The circuit board assembly 10c includes the mainboard 1c, the electrical connection board 2c, the connector 6f, and the flexible circuit board 5f. In the thickness direction Z of the electronic device, the electrical connection board 2c is mounted on the mainboard 1c, and the connector 6f is mounted on the electrical connection board 2c. The connector 6f includes the male end 61f and the female end 62f. The male end 61f of the connector 6f is mounted on the electrical connection board 2c, and the female end 62f of the connector 6f is mounted on the flexible circuit board 5f. The flexible circuit board 5f is connected to the connector 6f through the mating between the female end 62f and the male end 61f of the connector 6f. In this embodiment, the height of the connector 6f is adjusted by arranging the electrical connection board 2c to adjust the height difference between the two ends of the flexible circuit board 5f, so that the flexible circuit board 5f obtains a good form, thereby improving the service life of the flexible circuit board 5f. The electrical connection board 2c in the embodiment shown in FIG. 13 can increase the heights of the two ends of the flexible circuit board 5f.

Therefore, to implement a proper form of the flexible circuit board 5f, the height difference between the two ends of the flexible circuit board 5f needs to be controlled, and the height difference is limited by an actual height difference between the sensor 4f and the connector 6f. When a height of a position at which the sensor 4f is located is fixed, the proper bent form of the flexible circuit board 5f is related to the height of the position at which the connector 6f is located.

Therefore, in the embodiments of this application, an auxiliary component is added to the electronic device. The auxiliary component is located between the connector 6f and the sensor 4f in the thickness direction of the electronic device, and can help adjust the distance between the connector 6f and the sensor 4f in the thickness direction Z of the electronic device, so that the bent form of the flexible circuit board 5f can be adjusted without changing the distance between the connector 6f and the sensor 4f in the width direction X of the electronic device.

It is defined that a height L0 (a matching height for short below) at which the connector 6f is located is a distance (shown in FIG. 13) between the connector 6f and the upper surface of the mainboard when the flexible circuit board 5f has a proper bent form. It should be noted that a distance between the sensor 4f and the mainboard 1c in the thickness direction of the electronic device is a fixed value. Therefore, in this embodiment, the upper surface of the mainboard 1c is used as a base surface, and a distance between the base surface and the highest end surface of the connector 6f is the above-described matching height L0.

For example, when a standard connector 6f and an electrical connection board 2c having a minimum board thickness are selected, refer to the following Table 2 for the details of a matching height of the flexible circuit board 5f that can be satisfied by the embodiment shown in FIG. 13.

**Table 2**

| No. | Connector height (mm) | Minimum thickness (mm) of the electrical connection board | Required matching height L0 (mm) |
|---|---|---|---|
| 1 | 0.6 | 0.3 | 0.9 |
| 2 | 0.5 | 0.3 | 0.8 |

It should be noted that because the connector 6f is a standard piece, the height of the connector 6f is generally a fixed value (for example, 0.5 mm or 0.6 mm), and cannot be randomly changed as required. The electrical connection board 2c is limited by the minimum board thickness because processing processes and stiffness affect each other. A minimum thickness of the electrical connection board 2c is generally 0.3 mm without plastic encapsulation.

It can be known from the foregoing Table 2 that when the height of the connector 6f is 0.6 mm and the thickness of the electrical connection board 2c is 0.3 mm, it can be satisfied that the matching height L0 is 0.9 mm. When the height of the connector 6f is 0.5 mm and the thickness of the electrical connection board 2c is 0.3 mm, it can be satisfied that the matching height L0 is 0.8 mm.

Obviously, when a standard connector and an electrical connection board having a minimum thickness are selected, a matching height below 0.8 mm cannot be satisfied. When the required matching height L0 is less than 0.8 mm, the connector 6f needs to be customized. The customized connector 6f requires a complex process and a long process cycle, and further requires a large number of experiments and tests, affecting a product preparation cycle.

In view of this, in some embodiments, a recessed structure may be disposed on the mainboard, and through the cooperation between the electrical connection board and the recessed structure, a range of the matching height that can be implemented is expanded.

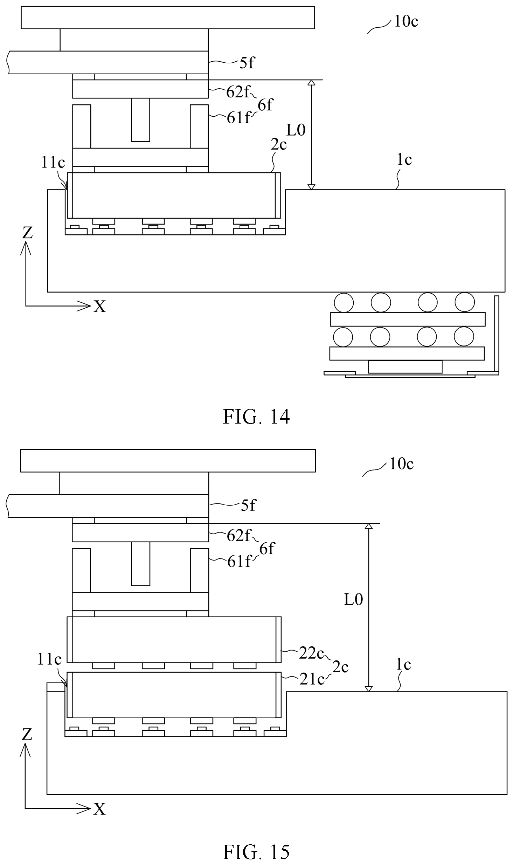

Specifically, FIG. 14 is a schematic diagram of a circuit board assembly 10c in another embodiment. The circuit board assembly 10c includes the mainboard 1c, the electrical connection board 2c, the connector 6f, and the flexible circuit board 5f. In the thickness direction Z of the electronic device, the mainboard 1c is provided with a groove 11c, and the groove 11c has the foregoing recessed structure. A partial structure of the electrical connection board 2c is disposed in the groove 11c. The male end 61f of the connector 6f is mounted on the electrical connection board 2c, and the female end 62f of the connector 6f is mounted on the flexible circuit board 5f. The flexible circuit board 5f is connected to the connector 6f through the mating between the female end 62f and the male end 61f of the connector 6f.

In this embodiment, the groove 11c is provided in the mainboard 1c, and the depth of the groove 11c may be adjusted according to an actual requirement. A partial structure of the electrical connection board 2c is disposed in the groove 11c, and the depth of the groove 11c may be adjusted according to a required matching height to adjust the height of the connector 6f, so that a height L0 of less than 0.8 mm can still be reached when the standard connector 6f and the electrical connection board 2c having the minimum thickness are selected for the circuit board assembly 10c, thereby achieving a proper height difference between the two ends of the flexible circuit board 5f and further making the flexible circuit board 5f obtain a better form.

To ensure that the mainboard 1c has sufficient supporting strength for the electrical connection board 2c, the depth of the groove 11c is less than 70% of the thickness of the mainboard 1c. For example, when the thickness of the mainboard 1c is 0.6 mm, the depth of the groove 11c may range from 0 to 0.4 mm.

For example, when a standard connector 6f and an electrical connection board 2c having a minimum board thickness are selected, refer to the following Table 3 for the details of a matching height of the flexible circuit board 5f that can be satisfied by the embodiment shown in FIG. 14.

**Table 3**

| No. | Connector height (mm) | Minimum thickness (mm) of the electrical connection board | Depth (mm) of the groove in the mainboard | Required matching height L0 (mm) |
|---|---|---|---|---|
| 1 | 0.6 | 0.3 | 0 | 0.9 |
| 2 | 0.6 | 0.3 | 0.1 | 0.8 |
| 3 | 0.6 | 0.3 | 0.2 | 0.7 |
| 4 | 0.6 | 0.3 | 0.3 | 0.6 |
| 5 | 0.6 | 0.3 | 0.4 | 0.5 |
| 6 | 0.5 | 0.3 | 0 | 0.8 |
| 7 | 0.5 | 0.3 | 0.1 | 0.7 |
| 8 | 0.5 | 0.3 | 0.2 | 0.6 |
| 9 | 0.5 | 0.3 | 0.3 | 0.5 |
| 10 | 0.5 | 0.3 | 0.4 | 0.4 |

It should be noted that because the connector 6f is a standard piece, the height of the connector 6f is generally a fixed value (for example, 0.5 mm or 0.6 mm), and cannot be randomly changed as required. The electrical connection board 2c is limited by the minimum board thickness because processing processes and stiffness affect each other. A minimum thickness of the electrical connection board 2c is generally 0.3 mm without plastic encapsulation.

It can be known from the foregoing Table 3 that when the height of the connector 6f is 0.6 mm, the thickness of the electrical connection board 2c is 0.3 mm, and the depth of the groove 11c is 0, it can be satisfied that the matching height L0 is 0.9 mm. When the height of the connector 6f is 0.6 mm, the thickness of the electrical connection board 2c is 0.3 mm, and the depth of the groove 11c is 0.1 mm, it can be satisfied that the matching height L0 is 0.8 mm. When the height of the connector 6f is 0.6 mm, the thickness of the electrical connection board 2c is 0.3 mm, and the depth of the groove 11c is 0.2 mm, it can be satisfied that the matching height L0 is 0.7 mm. When the height of the connector 6f is 0.6 mm, the thickness of the electrical connection board 2c is 0.3 mm, and the depth of the groove 11c is 0.3 mm, it can be satisfied that the matching height L0 is 0.6 mm. When the height of the connector 6f is 0.6 mm, the thickness of the electrical connection board 2c is 0.3 mm, and the depth of the groove 11c is 0.4 mm, it can be satisfied that the matching height L0 is 0.5 mm.

When the height of the connector 6f is 0.5 mm, the thickness of the electrical connection board 2c is 0.3, and the depth of the groove 11c is 0, it can be satisfied that the matching height L0 is 0.8 mm. When the height of the connector 6f is 0.5 mm, the thickness of the electrical connection board 2c is 0.3 mm, and the depth of the groove 11c is 0.1 mm, it can be satisfied that the matching height L0 is 0.7 mm. When the height of the connector 6f is 0.5 mm, the thickness of the electrical connection board 2c is 0.3 mm, and the depth of the groove 11c is 0.2 mm, it can be satisfied that the matching height L0 is 0.6 mm. When the height of the connector 6f is 0.5 mm, the thickness of the electrical connection board 2c is 0.3 mm, and the depth of the groove 11c is 0.3 mm, it can be satisfied that the matching height L0 is 0.5 mm. When the height of the connector 6f is 0.5 mm, the thickness of the electrical connection board 2c is 0.3 mm, and the depth of the groove 11c is 0.4 mm, it can be satisfied that the matching height L0 is 0.4 mm.

Therefore, in this embodiment, the connector 6f of 0.6 mm and the electrical connection board 2c having the minimum thickness can be used to implement a matching height of 0.5 mm to 0.9 mm, and the connector 6f of 0.5 mm and the electrical connection board 2c having the minimum thickness can be used to implement a matching height of 0.4 mm to 0.8 mm. When the connector 6f is not replaced, a larger adjustable range can be implemented. While the bent form of the flexible circuit board 5f is improved, the connector 6f does not need to be customized, thereby reducing the manufacturing costs of the connector 6f.

In some embodiments, a quantity of electrical connection boards may alternatively be properly increased to expand the range of height matching. FIG. 15 is a schematic diagram of the circuit board assembly 10c in another embodiment. The circuit board assembly 10c includes the mainboard 1c, the electrical connection board 2c, the connector 6f, and the flexible circuit board 5f. In the thickness direction Z of the electronic device 100, the mainboard 1c is provided with a groove 11c, and the groove 11c has the foregoing recessed structure. The electrical connection board 2c includes a first board 21c and a second board 22c, a partial structure of the first board 21c is disposed in the groove 11c, the second board 22c is disposed on the first board 21c, and the first board 21c is electrically connected to the second board 22c. The male end 61f of the connector 6f is mounted on the second board 22c, and the female end 62f of the connector 6f is mounted on the flexible circuit board 5f. The flexible circuit board 5f is connected to the connector 6f through the mating between the female end 62f and the male end 61f of the connector 6f.

In this embodiment, a matching height L0 ranging from 0.8 mm to 1.2 mm may be implemented by a connector 6f of 0.6 mm, and a matching height L0 of 0.7 mm to 1.1 mm may be implemented by a connector 6f of 0.5 mm.

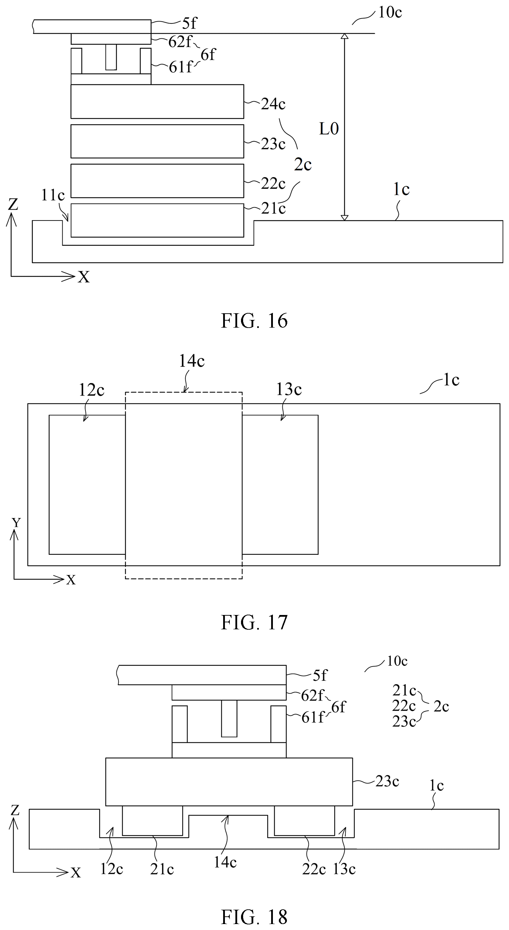

For another example, FIG. 16 is a schematic diagram of the circuit board assembly 10c in another embodiment. The circuit board assembly 10c includes the mainboard 1c, the electrical connection board 2c, the connector 6f, and the flexible circuit board 5f. In the thickness direction Z of the electronic device 100, the mainboard 1c is provided with a groove 11c, and the groove 11c has the foregoing recessed structure. The electrical connection board 2c includes the first board 21c, the second board 22c, a third board 23c, and a fourth board 24c. A partial structure of the first board 21c is disposed in the groove 11c. The second board 22c is disposed on the first board 21c. The third board 23c is disposed on the second board 22c. The fourth board 24c is disposed on the third board 23c. The first board 21c, the second board 22c, the third board 23c, and the fourth board 24c are electrically connected to each other. The male end 61f of the connector 6f is mounted on the fourth board 24c, and the female end 62f of the connector 6f is mounted on the flexible circuit board 5f. The flexible circuit board 5f is connected to the connector 6f through the mating between the female end 62f and the male end 61f of the connector 6f.

Certainly, three, five, or another quantity of electrical connection boards 2c may alternatively be stacked. This may be specifically limited according to an actual situation, and is not limited in this embodiment herein.

In this embodiment, the range of the matching height is further refined by increasing the number of the electrical connection board 2c and through the cooperation between the electrical connection board 2c and the groove 11c on the mainboard 1c.

The following Table 4 and Table 5 are a comparison between a matching height L0 that can be satisfied by arranging the groove 11c in the embodiment shown in FIG. 16 and a matching height L0 that can be satisfied without arranging the groove 11c when the standard connector 6f and the electrical connection board 2c having the minimum board thickness are selected.

**Table 4**

| No. | Connector height (mm) | Minimum thickness (mm) of the electrical connection board | Quantity of stacked electrical connection boards | Depth (mm) of the groove in the mainboard | Required matching height L0 (mm) |
|---|---|---|---|---|---|
| 1 | 0.6 | 0.3 | 4 | 0 | 1.8 |
| 2 | 0.6 | 0.3 | 4 | 0.1 | 1.7 |
| 3 | 0.6 | 0.3 | 4 | 0.2 | 1.6 |
| 4 | 0.6 | 0.3 | 4 | 0.3 | 1.5 |
| 5 | 0.6 | 0.3 | 4 | 0.4 | 1.1 |
| 6 | 0.5 | 0.3 | 3 | 0 | 1.7 |
| 7 | 0.5 | 0.3 | 4 | 0.1 | 1.6 |
| 8 | 0.5 | 0.3 | 4 | 0.2 | 1.5 |
| 9 | 0.5 | 0.3 | 4 | 0.3 | 1.4 |
| 10 | 0.5 | 0.3 | 4 | 0.4 | 1.3 |
| 11 | 0.5 | 0.3 | 3 | 0.2 | 1.2 |

**Table 5**

| No. | Connector height (mm) | Minimum thickness (mm) of the electrical connection board | Quantity of stacked electrical connection boards | Depth (mm) of the groove in the mainboard | Required matching height L0 (mm) |
|---|---|---|---|---|---|
| 1 | 0.6 | 0.3 | 4 | 0 | 1.8 |
| 2 | 0.5 | 0.3 | 4 | 0 | 1.7 |

It should be noted that because the connector 6f is a standard piece, the height of the connector 6f is generally a fixed value (for example, 0.5 mm or 0.6 mm), and cannot be randomly changed as required. The electrical connection board 2c is limited by the minimum board thickness because processing processes and stiffness affect each other. A minimum thickness of the electrical connection board 2c is generally 0.3 mm without plastic encapsulation.

It can be known from the foregoing Table 4 that when the height of the connector 6f is 0.6 mm, the total thickness of the electrical connection board 2c is 1.2 mm (0.3×4), and the depth of the groove 11c is 0, it can be satisfied that the matching height L0 is 1.8 mm. When the height of the connector 6f is 0.6 mm, the total thickness of the electrical connection board 2c is 1.2 mm, and the depth of the groove 11c is 0.1 mm, it can be satisfied that the matching height L0 is 1.7 mm. When the height of the connector 6f is 0.6 mm, the total thickness of the electrical connection board 2c is 1.2 mm, and the depth of the groove 11c is 0.2 mm, it can be satisfied that the matching height L0 is 1.6 mm. When the height of the connector 6f is 0.6 mm, the total thickness of the electrical connection board 2c is 1.2 mm, and the depth of the groove 11c is 0.3 mm, it can be satisfied that the matching height L0 is 1.5 mm. When the height of the connector 6f is 0.6 mm, the total thickness of the electrical connection board 2c is 0.9 mm, and the depth of the groove 11c is 0.0.4 mm, it can be satisfied that the matching height L0 is 1.1 mm.

When the height of the connector 6f is 0.5 mm, the total thickness of the electrical connection board 2c is 1.2 mm, and the depth of the groove 11c is 0, it can be satisfied that the matching height L0 is 1.7 mm. When the height of the connector 6f is 0.5 mm, the total thickness of the electrical connection board 2c is 1.2 mm, and the depth of the groove 11c is 0.1 mm, it can be satisfied that the matching height L0 is 1.6 mm. When the height of the connector 6f is 0.5 mm, the total thickness of the electrical connection board 2c is 1.2 mm, and the depth of the groove 11c is 0.2 mm, it can be satisfied that the matching height L0 is 1.5 mm. When the height of the connector 6f is 0.5 mm, the total thickness of the electrical connection board 2c is 1.2 mm, and the depth of the groove 11c is 0.3 mm, it can be satisfied that the matching height L0 is 1.4 mm. When the height of the connector 6f is 0.5 mm, the total thickness of the electrical connection board 2c is 1.2 mm, and the depth of the groove 11c is 0.4 mm, it can be satisfied that the matching height L0 is 1.3 mm. When the height of the connector 6f is 0.5 mm, the total thickness of the electrical connection board 2c is 0.9 mm, and the depth of the groove 11c is 0.0.2 mm, it can be satisfied that the matching height L0 is 1.2 mm.

It can be known from the foregoing Table 5 that when the height of the connector 6f is 0.6 mm, the total thickness of the electrical connection board 2c is 1.2 mm, and the depth of the groove 11c is 0, it can be satisfied that the matching height L0 is 1.8 mm. When the height of the connector 6f is 0.5 mm, the total thickness of the electrical connection board 2c is 1.2 mm, and the depth of the groove 11c is 0, it can be satisfied that the matching height L0 is 1.7 mm.

Therefore, through the comparison of data in Table 4 (this embodiment) and data in Table 5 (Comparative example), in this embodiment, after the groove 11c is disposed, a matching height L0 ranging from 1.1 mm to 1.8 mm at intervals of 0.1 mm may be implemented, while in the comparative example, heights of only 1.7 mm and 1.8 mm are implemented when the groove 11c is not disposed. In this embodiment, through the cooperation of the electrical connection board 2c and the groove 11c, an adjustable range of the matching height can be larger.

In the foregoing embodiments, the mainboard is provided with one groove for accommodating the electrical connection board. In other embodiments, the mainboard may alternatively be provided with more than one groove for accommodating the electrical connection board.

Specifically, in some embodiments, FIG. 17 is a schematic top view of the mainboard 1c. The mainboard 1c is provided with a first groove 12c, a second groove 13c, and an element placement area 14c (represented by a dashed-line box in the figure). The element placement area 14c is located between the first groove 12c and the second groove 13c. An element is arranged in the element placement area 14c. The first groove 12c and the second groove 13c have the foregoing recessed structures.

FIG. 18 is a schematic diagram of the circuit board assembly 10c using the mainboard 1c in FIG. 17 in another embodiment. Referring to FIG. 17 and FIG. 18, the circuit board assembly 10c includes the mainboard 1c, the electrical connection board 2c, the connector 6f, and the flexible circuit board 5f. The electrical connection board 2c includes the first board 21c, the second board 22c, and the third board 23c. A partial structure of the first board 21c is disposed in the first groove 12c, a partial structure of the second board 22c is disposed in the second groove 13c, the third board 23c is disposed on the first board 21c and the second board 22c, and the third board 23c is electrically connected to both the first board 21c and the second board 22c. The third board 23c is connected to the male end 61f of the connector 6f. The female end 62f of the connector 6f is mounted on the flexible circuit board 5f. The flexible circuit board 5f is connected to the connector 6f through the mating between the female end 62f and the male end 61f of the connector 6f.

In this embodiment, elements need to be arranged in the element placement area 14c of the mainboard 1c. To avoid the elements arranged on the mainboard 1c, grooves are opened in areas on two sides of the element placement area 14c of the mainboard 1c, thereby implementing element arrangement while satisfying the matching of any matching height of the flexible circuit board 5f.

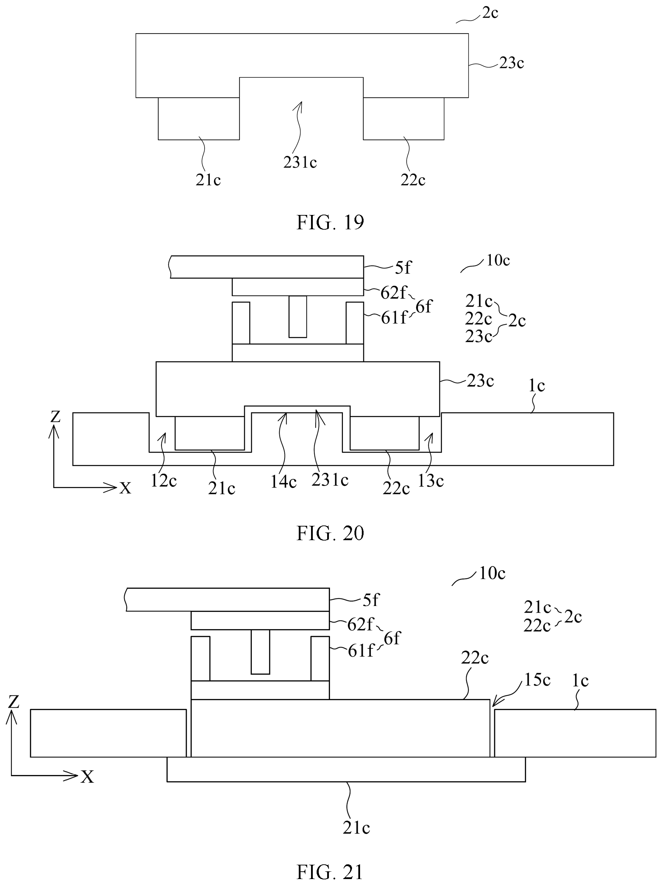

In some embodiments, FIG. 19 is a schematic diagram of an electrical connection board 2c in another embodiment. FIG. 20 is a schematic diagram of a circuit board assembly 10c using the electrical connection board 2c in FIG. 19 and the mainboard 1c in FIG. 17 in another embodiment. With reference to FIG. 17, FIG. 19, and FIG. 20, the electrical connection board 2c includes the first board 21c, the second board 22c, and the third board 23c. The third board 23c is provided with a clearance groove 231c.

The first board 21c is disposed in the first groove 12c, the second board 22c is disposed in the second groove 13c, and the third board 23c is disposed on the first board 21c and the second board 22c, and is connected to the male end 61f of the connector 6f. The female end 62f of the connector 6f is mounted on the flexible circuit board 5f. The flexible circuit board 5f is connected to the connector 6f through the mating between the female end 62f and the male end 61f of the connector 6f.

The depth of the first groove 12c is greater than the thickness of the first board 21c, the depth of the second groove 13c is greater than the thickness of the second board 22c, and the third board 23c is provided with a clearance groove 231c, to avoid interference between the third board 23c and the element placement area 14c, to ensure that the third board 23c is electrically connected to the first board 21c and the second board 22c, and ensure that cooperation between the electrical connection board 2c and the mainboard 1c can satisfy a required height.

FIG. 21 is a schematic diagram of the circuit board assembly 10c in another embodiment. The circuit board assembly 10c includes the mainboard 1c, the electrical connection board 2c, the connector 6f, and the flexible circuit board 5f. In the thickness direction Z of the electronic device, the mainboard 1c has a penetrating through hole 15c, and the through hole 15c has the foregoing recessed structure. The electrical connection board 2c includes the first board 21c and the second board 22c. The first board 21c is connected to the mainboard 1c, and seals the bottom of the through hole 15c. A partial structure of the second board 22c is located in the through hole 15c and is disposed on the first board 21c. The first board 21c is electrically connected to the second board 22c. The male end 61f of the connector 6f is mounted on the second board 22c, and the female end 62f of the connector 6f is mounted on the flexible circuit board 5f. The flexible circuit board 5f is connected to the connector 6f through the mating between the female end 62f and the male end 61f of the connector 6f.

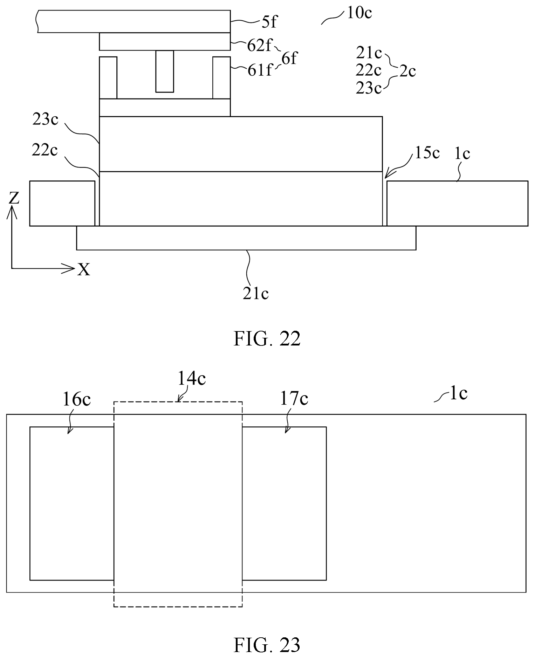

Alternatively, in some embodiments, FIG. 22 is a schematic diagram of the circuit board assembly 10c in another embodiment. Based on the embodiment shown in FIG. 21, the electrical connection board 2c may further include the third board 23c. The third board 23c is disposed on the second board 22c, and is configured to electrically connect the second board 22c to the connector 6f. Alternatively, based on a required matching height, the electrical connection board 2c may further include the fourth board, a fifth board, and the like that are stacked on the third board 23c.

In the foregoing embodiments, the mainboard is provided with one through hole for accommodating the electrical connection board. In other embodiments, the mainboard may alternatively be provided with more than one through hole for accommodating the electrical connection board.

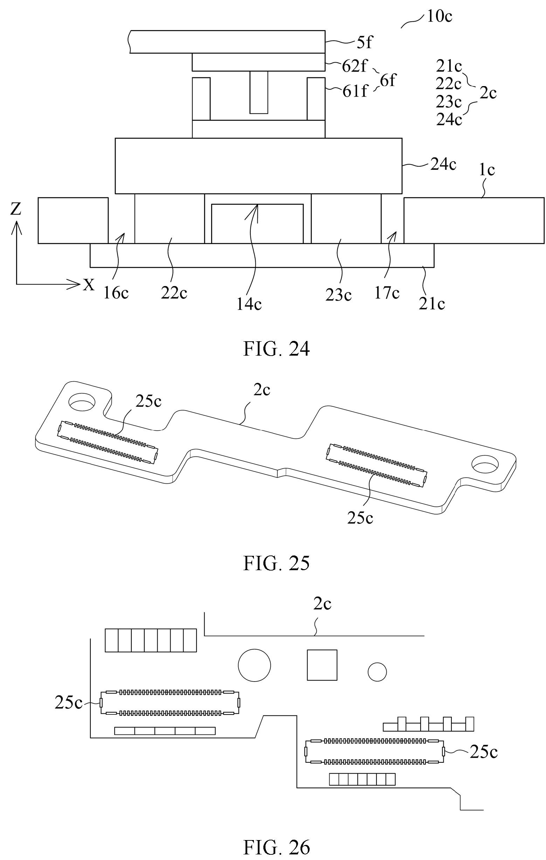

Specifically, FIG. 23 is a schematic top view of the mainboard 1c, and FIG. 24 is a schematic diagram of the circuit board assembly 10c using the mainboard 1c in FIG. 23 in another embodiment. With reference to FIG. 23 and FIG. 24, the mainboard 1c is provided with a first hole 16c, a second hole 17c, and the element placement area 14c (represented by a dashed-line box in the figure). The first hole 16c and the second hole 17c penetrate the mainboard 1c in the thickness direction Z of the electronic device. The element placement area 14c is located between the first hole 16c and the second hole 17c. An element is arranged in the element placement area 14c. The first hole 16c and the second hole 17c have the foregoing recessed structures.

The circuit board assembly 10c includes the mainboard 1c, the electrical connection board 2c, the connector 6f, and the flexible circuit board 5f. The electrical connection board 2c includes the first board 21c, the second board 22c, the third board 23c, and the fourth board 24c. The first board 21c is connected to the mainboard 1c, and seals the bottom of the first hole 16c and the bottom of the second hole 17c. A partial structure of the second board 22c is located in the first hole 16c. A partial structure of the third board 23c is located in the second hole 17c. The fourth board 24c is disposed on the first board 21c and the second board 22c. The first board 21c, the second board 22c/the third board 23c, and the fourth board 24c are electrically connected to each other. The fourth board 24c is connected to the male end 61f of the connector 6f. The female end 62f of the connector 6f is mounted on the flexible circuit board 5f. The flexible circuit board 5f is connected to the connector 6f through the mating between the female end 62f and the male end 61f of the connector 6f.

In summary, the electrical connection board is configured for implementing height matching of a connector to adjust the height difference between the two ends of the flexible circuit board. In addition, the electrical connection board further needs to implement electrical connection of elements connected to two ends of the electrical connection board. Therefore, at least a part of structure of the electrical connection board can conduct electricity. Two specific embodiments of the electrical connection board are described in detail below.

In a specific embodiment, FIG. 25 is a schematic diagram of a structure of the electrical connection board 2c in a specific embodiment, and FIG. 26 is a schematic diagram of another view of FIG. 25. The electrical connection board 2c is made of a conductor, that is, the electrical connection board 2c can conduct electricity at each position. For example, the electrical connection board may be a printed circuit board (Printed Circuit Board, PC). The electrical connection board 2c in this embodiment can be configured for height matching, and can be further configured for arranging elements of the electronic device.

As shown in FIG. 25 and FIG. 26, a first pad 25c for soldering a connector is disposed on the electrical connection board 2c. Due to a high-density requirement of internal space of the electronic device 100, two or more connectors may be connected to the electrical connection board 2c, and two or more first pads 25c are correspondingly disposed.

In some embodiments, the electrical connection board 2c may be an original circuit board, for example, a sub-board, of the electronic device. Specifically, the electronic device may include a plurality of PCBs, and the plurality of PCBs are respectively configured for arranging electronic elements, to implement functions of the electronic elements, so that the electronic device can be normally used. At least some of the PCBs of the electronic device can be further configured for height matching, that is, at least some of the PCBs can be used as electrical connection boards.

As shown in the following Table 6, the electronic device may include five PCBs, namely, PCB1, PCB2, PCB3, PCB4, and PCB5. PCB2, PCB3, PCB4, and PCB5 are disposed on PCB1. PCB2, PCB3, PCB4, and PCBS may be a proximity light small board, an NFC spring holder board, a wide-angle CAM holder board, and an ambient light small board, respectively. At least some circuit boards of the five PCBs may be used as the electrical connection board 2c. For example, a proximity light small board, an NFC spring holder board, a wide-angle CAM holder board, or an ambient light small board may be used as the electrical connection board 2c.

**Table 6**

| No. | PCB | Name | Layer and stage | Board thickness/mm | Assembly/Secondary SMT |
|---|---|---|---|---|---|
| 1 | PCB1 | Mainboard | 14 layers, any quantity of stages | 0.6 | Assembled |
| 2 | PCB2 | U small board | 5 layers, any quantity of stages | 0.45 | Assembled |
| 3 | | Proximity light small board | 5 layers, any quantity of stages | 0.45 | Secondarily soldered to a sub-mainboard |
| 4 | PCB3 | Sub-board | 8 layers, any quantity of stages | 0.45 | Assembled |
| 5 | | S-type rigid board | 8 layers, any quantity of stages | 0.45 | Assembled |
| 6 | | NFC spring holder board | 8 layers, any quantity of stages | 0.45 | Secondarily soldered to a mainboard |
| 7 | | Wide-angle CAM holder board | 8 layers, any quantity of stages | 0.45 | Secondarily soldered to a mainboard |
| 8 | PCB4 | Ambient light small board | 5 layers, 1 stage | 1.2 | Secondarily soldered to a mainboard |
| 9 | PCB5 | Antenna side board | 8 layers, any quantity of stages | 0.6 | Assembled |

As shown in the foregoing table, the fourth column represents the layer and stage of each of the PCBs, where "layer" refers to a quantity of conductive layers of the PCB, and the conductive layer is a part covered by a copper foil on the PCB and may transmit a current and a signal. A PCB with a larger quantity of "layers" has a larger thickness. Therefore, PCB1 has a large quantity of conductive layers, and a recessed structure may be formed in PCB1.

"Stage" refers to a quantity of layers of laser-drilled holes on a PCB to implement high-density circuit connection. According to the quantity of layers of laser-drilled holes, PCBs may be classified into a one-stage board, a two-stage board, a three-stage board, and the like. The one-stage board represents a circuit board having only one layer of laser-drilled holes, that is, a circuit board having only one layer of non-metal holes. The two-stage board represents a circuit board having two layers of laser-drilled holes, that is, a circuit board having two layers of non-metal holes, and different conductive layers may be connected by the two layers of non-metal holes. A three-stage board represents a circuit board having three layers of laser-drilled holes, that is, a circuit board having three layers of non-metal holes, and different conductive layers may be connected by the three layers of non-metal holes.

In addition, as shown in the foregoing table, in some embodiments, during the assembly of the electronic device, when a proximity light small board, an NFC spring holder board, a wide-angle CAM holder board, and an ambient light small board are electrically connected to the flexible circuit board, partial structures of the proximity light small board, the NFC spring holder board, the wide-angle CAM holder board, and the ambient light small board may be used as the electrical connection boards to implement that the flexible circuit board has a proper bent form. Correspondingly, a PCB that is secondarily soldered to a mainboard/sub-mainboard shown in the sixth column represents that the PCB may be used as an electrical connection board, and is connected to the recessed structure in the mainboard/sub-mainboard through soldering. It should be noted that the foregoing limitation is merely a possible embodiment, and does not constitute an absolute limitation to the scope of protection of this application.

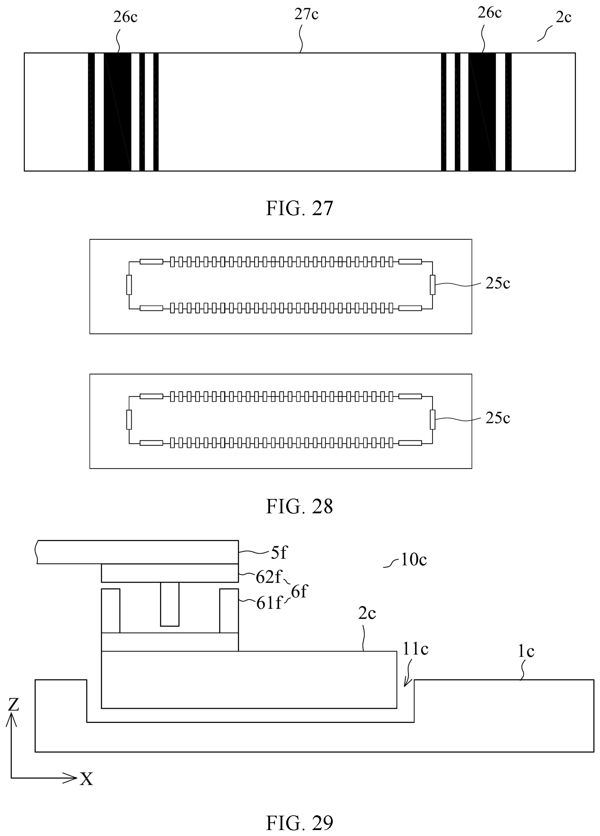

In some other embodiments, a partial structure of the electrical connection board can be electrically conductive, and a partial structure of the electrical connection board is electrically isolating. FIG. 27 is a schematic cross-sectional view of the electrical connection board 2c in still another embodiment. The electrical connection board 2c includes a conductive portion 26c (represented by a black cylinder in the figure) and a cladding portion 27c cladding the conductive portion 26c. The cladding portion 27c may be an injection-molded member, the conductive portion 26c is conductive metal (for example, a copper cylinder) embedded in the cladding portion 27c, and the conductive portion 26c is disposed penetrating the cladding portion 27c.

FIG. 28 is a layout diagram of the first pads 25c on two surfaces of the conductive portion of the electrical connection board 2c in FIG. 27 in the thickness direction Z of the electronic device. The electrical connection board 2c is respectively soldered and fixed to the connector and the mainboard by the first pads 25c on the two surfaces.

FIG. 29 is a schematic diagram of the circuit board assembly 10c using the electrical connection board 2c in FIG. 27 in another embodiment. The circuit board assembly 10c includes the mainboard 1c, the electrical connection board 2c, the connector 6f, and the flexible circuit board 5f. In the thickness direction Z of the electronic device 100, the mainboard 1c is provided with a groove 11c, and the groove 11c has the foregoing recessed structure. A partial structure of the electrical connection board 2c is disposed in the groove 11c. One end of the conductive portion 26c is electrically connected to the mainboard 1c, and the other end of the conductive portion 26c is electrically connected to the male end 61f of the connector 6f. The female end 62f of the connector 6f is mounted on the flexible circuit board 5f. The flexible circuit board 5f is connected to the connector 6f through the mating between the female end 62f and the male end 61f of the connector 6f.

In this embodiment, the electrical connection board 2c may be formed through injection molding processing, and during injection molding, conductive metal is embedded in an injection-molded member to form a structure including the conductive portion and the cladding portion. The minimum thickness of the electrical connection board 2c may be 0.1 mm, and the thickness of the electrical connection board 2c may alternatively be manufactured according to an actual requirement. For example, the thickness of the electrical connection board 2c may be manufactured as a standard piece ranging from 0.1 mm to 0.3 mm, and the electrical connection board 2c may be stacked as required, thereby shortening a production time and reducing manufacturing costs.

It should be noted that the electronic device may include one camera module or may include a plurality of camera modules. An example in which the electronic device includes two camera modules is used for description below.

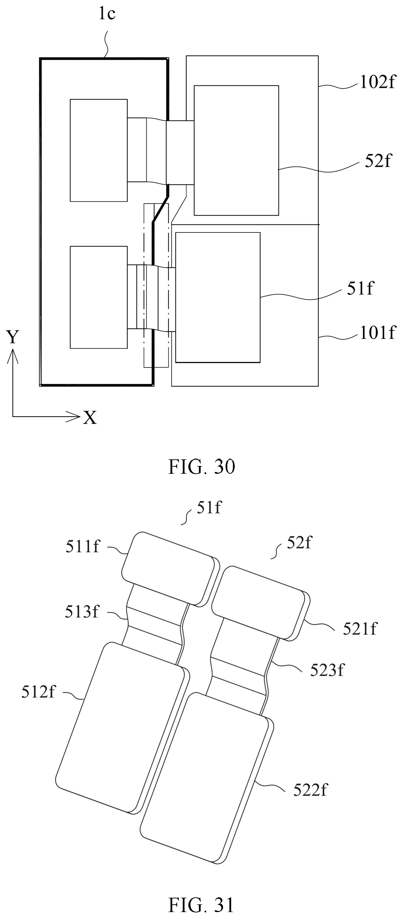

FIG. 30 is a schematic diagram of the two camera modules of the electronic device being connected to the mainboard. The electronic device includes two flexible circuit boards. The two flexible circuit boards are a first flexible circuit board 51f and a second flexible circuit board 52f, and the two camera modules are a first camera module 101f and a second camera module 102f. The first flexible circuit board 51f connects the mainboard 1c to the first camera module 101f, and the second flexible circuit board 52f connects the mainboard 1c to the second camera module 102f. It can be known from FIG. 30 that in the width direction X of the electronic device, because a distance between the first camera module 101f and the mainboard 1c is less than a distance between the second camera module 102f and the mainboard 1c, bent forms of the first flexible circuit board 51f and the second flexible circuit board 52f are different.

For the forms of the first flexible circuit board 51f and the second flexible circuit board 52f, refer to FIG. 31. The first flexible circuit board 51f includes a first connection end 511f, a second connection end 512f, and a first bending segment 513f connected between the first connection end 511f and the second connection end 512f, and the second flexible circuit board 52f includes a third connection end 521f, a fourth connection end 522f, and a second bending segment 523f connected between the third connection end 521f and the fourth connection end 522f. Referring to FIG. 30 and FIG. 31, the first connection end 511f of the first flexible circuit board 51f is configured to connect to the first camera module 101f, the second connection end 512f is configured to connect to the mainboard 1c, the third connection end 521f of the second flexible circuit board 52f is configured to connect to the second camera module 102f, and the fourth connection end 522f is configured to connect to the mainboard 1c.

Because the distance between the first camera module 101f and the mainboard 1c is less than the distance between the second camera module 102f and the mainboard 1c in the width direction X of the electronic device, a distance between the first connection end 511f of the first flexible circuit board 51f and the second connection end 512f is less than a distance between the third connection end 521f of the second flexible circuit board 52f and the fourth connection end 522f. In the embodiment shown in FIG. 30, after the first flexible circuit board 51f and the second flexible circuit board 52f are bent, the first bending segment 513f of the first flexible circuit board 51f is closer to the mainboard 1c. The first bending segment 513f of the first flexible circuit board 51f interferes with the mainboard 1c. The mainboard 1c (the contour of the mainboard is shown by a bold solid line in FIG. 30) needs to hollow out a partial structure (represented by a dot dash position in the figure) to avoid the first flexible circuit board 51f. However, elements cannot be arranged in the hollowed-out positions of the mainboard 1c, affecting the utilization of the mainboard 1c.

The foregoing technical problem can be resolved by changing the bent form of the first flexible circuit board 51f, so that the first bending segment 513f of the first flexible circuit board 51f does not interfere with the mainboard 1c, and it is not necessary to hollow out the mainboard 1c. Specifically, the manner of adjusting the bent form of the flexible circuit board described in the foregoing embodiments may be used. That is, an electrical connection board may be added between the mainboard 1c and the second connection end 512f of the first flexible circuit board 51f, and a recessed structure is provided in the mainboard 1c. A position of the second connection end 512f in the thickness direction of the electronic device is adjusted using a combination of the electrical connection board and the recessed structure to adjust a distance between the first connection end 511f and the second connection end 512f in the thickness direction of the electronic device, to change the bent form of the first flexible circuit board 51f, so that the first bending segment 513f of the first flexible circuit board 51f does not interfere with the mainboard 1c.

It should be noted that soldering may be used for connection manners of the flexible circuit board, the connector, the electrical connection board, and the mainboard in the foregoing embodiments. A soldering process is described below by using the embodiment shown in FIG. 14 as an example. Other embodiments are similar to this.

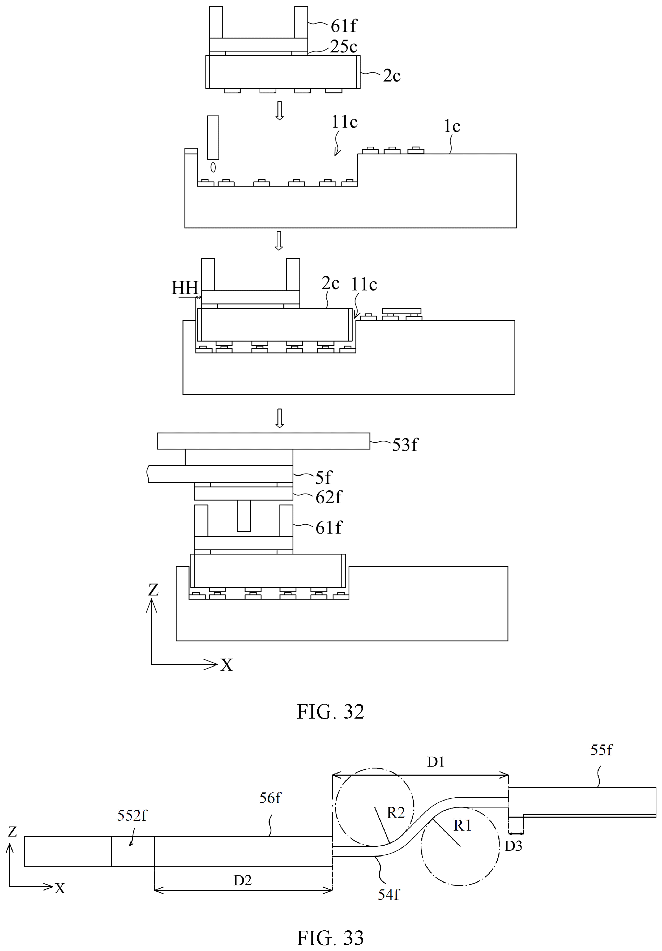

FIG. 32 is a schematic flowchart of soldering in the embodiment shown in FIG. 14. A soldering process of the circuit board assembly 10c may specifically include the following steps.

S1: Solder the male end 61f of the connector 6f to the first pad 25c on an upper end face of the electrical connection board 2c.

S2: Manufacture the groove 11c in the mainboard 1c, and spray solder to an inner wall of the groove 11c.

S3: Place the electrical connection board 2c in the groove 11c of the mainboard 1c, and solder the first pad 25c on the outer periphery of the electrical connection board 2c to the solder on the inner wall of the groove 11c to form a concave-shaped solder joint structure, thereby improving structural strength.

S4: Solder the female end 62f of the connector 6f to the flexible circuit board 5f, and plug the female end 62f of the connector 6f to the male end 61f to implement locking of the connector 6f, thereby completing the soldering of the circuit board assembly 10c.

In step S3, when the electrical connection board 2c and the mainboard 1c are assembled, a spacing between the electrical connection board 2c and an inner side wall of the groove 11 c is HH, and HH may be 0.1 mm ≤ HH ≤ 1 mm, thereby ensuring that a partial structure of the electrical connection board 2c can be mounted in the groove 11c. After the soldering of the electrical connection board 2c and the groove 11c is completed, the solder can fill the spacing between the electrical connection board 2c and the groove 11c, thereby ensuring connection strength. After step S4, the circuit board assembly 10c may be mounted into the electronic device 100.

Specifically, a side of the flexible circuit board 5f away from the female end 62f may be further provided with a reinforcing board 53f to improve the flexibility of the flexible circuit board 5f, thereby improving the strength of a plugging part of the flexible circuit board 5f, and facilitating plugging of the female end 62f of the connector 6f on the male end 61f of the connector 6f by the flexible circuit board 5f.

Alternatively, in some embodiments, a rigid board connector may be used instead of the foregoing connector to connect the flexible circuit board and the electrical connection board. A specific connection procedure may be as follows: an end of the flexible circuit board is inserted into the inside of the rigid board connector and the rigid board connector is in a clamping fit, and the rigid board connector is fixed to the electrical connection board through soldering.

It may be understood that the rigid board connector has an existing rigid board connector structure, and a specific structure is not described herein again in this embodiment.

It should be noted that the flexible circuit board described in the foregoing embodiments may be a structure made of a flexible material as a whole, or may be a structure made of a partial flexible material and a partial rigid material. A possible structure and material of the flexible circuit board are described below with reference to the accompanying drawings.

FIG. 33 is a schematic diagram of a structure of the flexible circuit board 5f in an embodiment. The flexible circuit board 5f may be a board made of a rigid-flex board. Specifically, the flexible circuit board 5f includes a deformation segment 54f and a first connection segment 55f and a second connection segment 56f that are connected to two ends of the deformation segment 54f, and the deformation segment 54f electrically connects the first connection segment 55f to the second connection segment 56f. The deformation segment 54f is made of a flexible material, and the first connection segment 55f and the second connection segment 56f are made of a rigid material.

The first connection segment 55f and the second connection segment 56f are configured to connect to electronic elements. For example, when the flexible circuit board is configured to connect the mainboard to the camera module, the first connection segment 55f is configured to electrically connect to a connector on the mainboard, and the second connection segment 56f is configured to electrically connect to a sensor of the camera module.

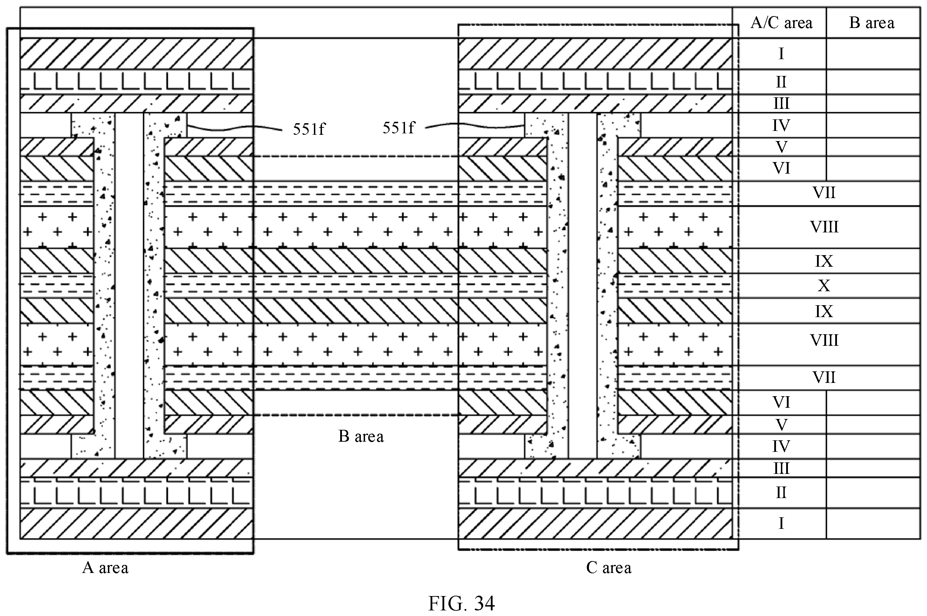

FIG. 34 is a schematic cross-sectional view of FIG. 33, and sequence numbers on the rightmost side of FIG. 34 are configured for marking layers of the flexible circuit board. As can be seen from the figure, the flexible circuit board 5f includes a plurality of coating layers, and the flexible circuit board 5f is a symmetrical structure using a layer with the sequence number X as a base layer. In the figure, an area A (an area shown by a bold dot dash line in FIG. 34) is the first connection segment 55f, an area B (an area shown by a bold dashed line in FIG. 34) is the deformation segment 54f, and an area C (an area shown by a bold double dot dash line in FIG. 34) is the second connection segment 56f. Because the deformation segment 54f needs to have a bent form, a material of the deformation segment 54f is not identical with that of the first connection segment 55f and the second connection segment 56f, so that the rigidity of the deformation segment 54f is lower than that of the first connection segment 55f and the second connection segment 56f. For example, this may be implemented by reducing, in the deformation segment 54f, a coating layer that improves structural rigidity.

It may be understood that a second pad 551f configured for soldering is disposed in both the first connection segment 55f and the second connection segment 56f, and the second pad 551f extends through a plurality of coating layers (extending from an upper IV layer to a lower IV layer).

In some embodiments, for details of materials and thicknesses of the coating layers of the flexible circuit board 5f in FIG. 34, refer to the following Table 7.

**Table 7**

| No. | Material | Thickness minimum value (µm) | Thickness maximum value (µm) |
|---|---|---|---|
| I | Stainless steel reinforcing board | 75 | 300 |
| II | Binder | 30 | 120 |
| III | Solder resist layer | 12.5 | 50 |
| IV | Copper plating layer | 8 | 32 |
| V | Electrolytic copper foil | 6 | 24 |
| VI | Polypropylene layer | 12.5 | 50 |
| VII | Polyimide covering film | 6 | 24 |
| VIII | Binder covering film | 7.5 | 30 |
| IX | Copper | 6 | 24 |
| X | Polyimide base layer | 10 | 40 |
| IX | Copper | 6 | 24 |
| VIII | Binder covering film | 7.5 | 30 |
| VII | Polyimide covering film | 6 | 24 |
| VI | Polypropylene layer | 12.5 | 50 |
| V | Electrolytic copper foil | 6 | 24 |
| IV | Copper plating layer | 8 | 32 |
| III | Solder resist layer | 12.5 | 50 |
| II | Binder | 30 | 120 |
| I | Stainless steel reinforcing board | 75 | 300 |

It should be noted that the material and the thickness of each layer of the flexible circuit board in the foregoing Table 7 are merely a possible embodiment, and does not constitute an absolute limitation to the scope of protection of this application.

Still referring to FIG. 33, in the thickness direction Z of the electronic device 100, the first connection segment 55f is located above the second connection segment 56f. The deformation segment 54f has a bent form, and inner and outer angles formed by bending are both smooth circular arc shapes.

After being bent, a radius of an arc-shaped bend formed at an end of the deformation segment 54f close to the first connection segment 55f is a first radius R1, and a radius of an arc-shaped bend formed at an end of the deformation segment 54f close to the second connection segment 56f is a second radius R2.

In some embodiments, when the flexible circuit board 5f is applied to a dynamic scenario, R1 ≤ 0.6 mm, and/or, R2 ≤ 0.6 mm, HA copper may be used for the IX layer in the deformation segment 54f, and HA copper has an excellent bending characteristic, to prevent a bending angle at two ends of the deformation segment 54f from being excessively small and consequently avoid fracturing at the two ends of the deformation segment 54f. In some other embodiments, when the flexible circuit board 5f is applied to a static scenario, R1 ≤ 0.5, and/or, R2 ≤ 0.6, HA copper may be used for the IX layer in the deformation segment 54f.

Preferably, R1 > 1 mm, and R2 > 1 mm.

In some embodiments, a 12-µm HA copper foil may be selected for all coating layers (for example, the IV layer, the V layer, and the IX layer) related to copper in the flexible circuit board 5f. The covering film of the VII layer is preferably a 12.5-µm polyimide covering film, and the covering film of the II layer is preferably a 15-µm binder. It should be noted that when HA copper is selected, it is necessary to use selective electroplating (hole-based copper electroplating) layer to increase the thickness of a hole-based copper layer, thereby ensuring reliable connection between the layers of the flexible circuit board.

Still referring to FIG. 33, in some embodiments, a minimum distance between the first connection segment 55f and the second connection segment 56f is D1 ≥ 2 mm, thereby ensuring that the deformation segment 54f has a proper bent form.

The first connection segment 55f and the second connection segment 56f are both provided with a conductive hole 552f configured for conduction, and the conductive hole 552f enables the first connection segment 55f to be electrically connected to a conductive layer of the second connection segment 56f. A minimum distance between the conductive hole 552f and the deformation segment 54f is D2 > 0.5 mm, to avoid an abnormality in a circuit due to electrical connection between the conductive hole 552f and the deformation segment 54f.

A minimum distance between a circuit on the first connection segment 55f and a connection position between the first connection segment 55f and the deformation segment 54f is D3 > 0.25 mm, that is, a distance exists between the circuit on the first connection segment 55f and the deformation segment 54f, thereby avoiding bending of the circuit on the first connection segment 55f in a process of bending the deformation segment 54f. Similarly, a minimum distance between a circuit on the second connection segment 56f and a connection position between the second connection segment 56f and the deformation segment 54f is D4 > 0.25 mm (D4 is the same as D3, and refer to D3 in the figure), that is, a distance exists between the circuit on the second connection segment 56f and the deformation segment 54f, thereby avoiding bending of the circuit on the second connection segment 56f in a process of bending the deformation segment 54f.

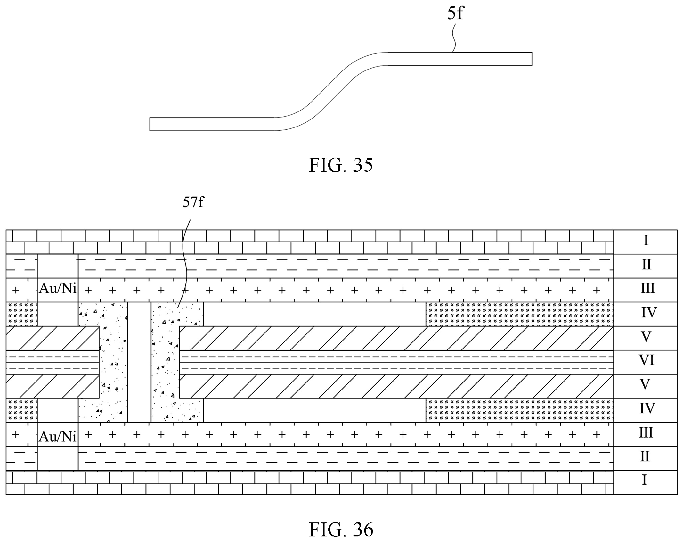

FIG. 35 is a schematic diagram of the flexible circuit board 5f in another embodiment. The flexible circuit board 5f may be entirely made of a flexible material, and the two ends of the flexible circuit board 5f are configured for being connected to electronic elements. For example, when the flexible circuit board 5f is configured to connect the mainboard to the camera module, the two ends of the flexible circuit board 5f are respectively electrically connected to a connector on the mainboard and a sensor of the camera module.

FIG. 36 is a schematic cross-sectional view of FIG. 35, and sequence numbers on the rightmost side of FIG. 36 are configured for marking layers of the flexible circuit board. As can be seen from the figure, the flexible circuit board 5f includes a plurality of coating layers, and the flexible circuit board 5f is a symmetrical structure using a layer with the sequence number VI as a base layer. When the flexible circuit board 5f has a bent form, inner and outer angles formed by bending are both smooth circular arc shapes.

It may be understood that the flexible circuit board 5f in the figure is provided with a third pad 57f configured for soldering, and the third pad 57f extends through a plurality of coating layers (extending from an upper IV layer to a lower IV layer). The III layer in the figure is provided with gold/nickel, and a main objective of the III layer is to block copper and air to prevent oxidation.

In some embodiments, for details of materials and thicknesses of the coating layers of the flexible circuit board 5f in FIG. 36, refer to the following Table 8.

**Table 8**

| No. | Material | Thickness minimum value (µm) | Thickness maximum value (µm) |
|---|---|---|---|
| I | Electromagnetic shielding layer | 7.5 | 30 |
| II | Polyimide covering film | 6.25 | 25 |
| III | Binder covering film | 10 | 40 |
| IV | Electroplated copper (button type) | 0 | 0 |
| V | Copper | 6 | 24 |
| VI | Polyimide base layer | 12.5 | 50 |
| V | Copper | 6 | 24 |
| IV | Electroplated copper (button-type) | 0 | 0 |
| III | Binder covering film | 10 | 40 |
| II | Polyimide covering film | 6.25 | 25 |
| I | Electromagnetic shielding layer | 7.5 | 30 |

It can be known from the foregoing Table 8 that it can be understood that the flexible circuit board 5f may not be provided with electroplated copper (button-type) of the IV layer. Alternatively, the flexible circuit board 5f may be provided with electroplated copper (button-type) of the IV layer and the thickness of the electroplated copper (button-type) ranges from 3 µm to 150 µm.

It should be noted that the material and the thickness of each layer of the flexible circuit board in the foregoing Table 8 are merely a possible embodiment, and does not constitute an absolute limitation to the scope of protection of this application.

The foregoing describes an embodiment in which the circuit board assembly is used in a scenario of a camera module. In another embodiment, the circuit board assembly may alternatively be used in another scenario of an electronic device. The application of the circuit board assembly to a charging scenario of the electronic device is described in detail below.

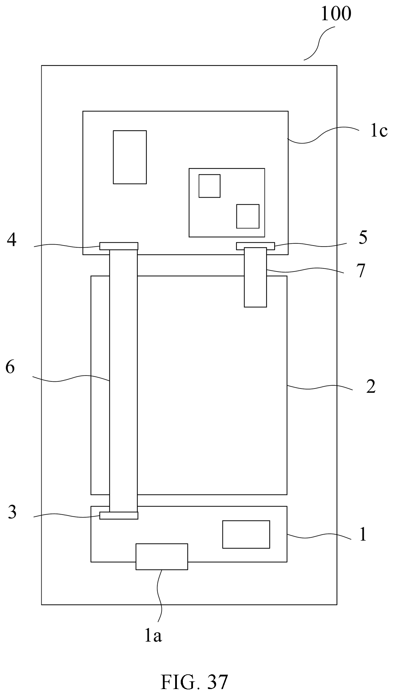

FIG. 37 is a schematic diagram of a charging scenario of an electronic device 100 (a bar-type phone) in an embodiment. The electronic device includes a mainboard 1c, a sub-board 1, a first battery 2, a first connector 3, a second connector 4, a third connector 5, a charging flexible circuit board 6, and a first battery flexible circuit board 7. The sub-mainboard 1c is provided with a charging port 1a. One end of the charging flexible circuit board 6 is electrically connected to the sub-board 1 by the first connector 3, and the other end of the charging flexible circuit board 6 is electrically connected to the mainboard 1c by the second connector 4. One end of the first battery flexible circuit board 7 is electrically connected to the mainboard 1c by the third connector 5, and the other end of the first battery flexible circuit board 7 is electrically connected to the first battery 2. That is, a charging current of an external charging cable enters the sub-mainboard 1c through the charging port 1a, then enters a battery management chip of the mainboard 1c through the charging flexible circuit board 6, and finally enters the first battery 2 through the first battery flexible circuit board 7, thereby implementing a charging function.

In some embodiments, heights of the sub-board 1 and the first battery 2 in the thickness direction Z of the electronic device may be different, so that a partial structure of the charging flexible circuit board 6 connected to the first connector 3 has a bent shape (the remaining part may have a flat and straight form). To improve the bent form of the charging flexible circuit board 6 and reduce the risk of fracturing of the charging flexible circuit board 6, the height may be adjusted through the cooperation between the electrical connection board and the recessed structure, to satisfy that the charging flexible circuit board 6 has a proper bent form, thereby prolonging the service life of the charging flexible circuit board 6.

Similarly, heights of the mainboard 1c and the first battery 2 in the thickness direction Z of the electronic device may be different, so that a partial structure of the charging flexible circuit board 6 connected to the second connector 4 has a bent shape. To improve the bent form of the charging flexible circuit board and reduce the risk of fracturing of the charging flexible circuit board, the height may be adjusted through the cooperation between the electrical connection board and a recessed mechanism, to satisfy that the charging flexible circuit board 6 has a proper bent form, thereby prolonging the service life of the charging flexible circuit board 6.

Similarly, heights of the mainboard 1c and the first battery 2 in the thickness direction Z of the electronic device may be different, so that a partial structure of the first battery flexible circuit board 7 connected to the third connector 5 has a bent shape. To improve the bent form of the first battery flexible circuit board 7 and reduce the risk of fracturing of the first battery flexible circuit board 7, the height may be adjusted through the cooperation between the electrical connection board and a recessed mechanism, to satisfy that the battery flexible circuit board has a proper bent form, thereby prolonging the service life of the first battery flexible circuit board 7.

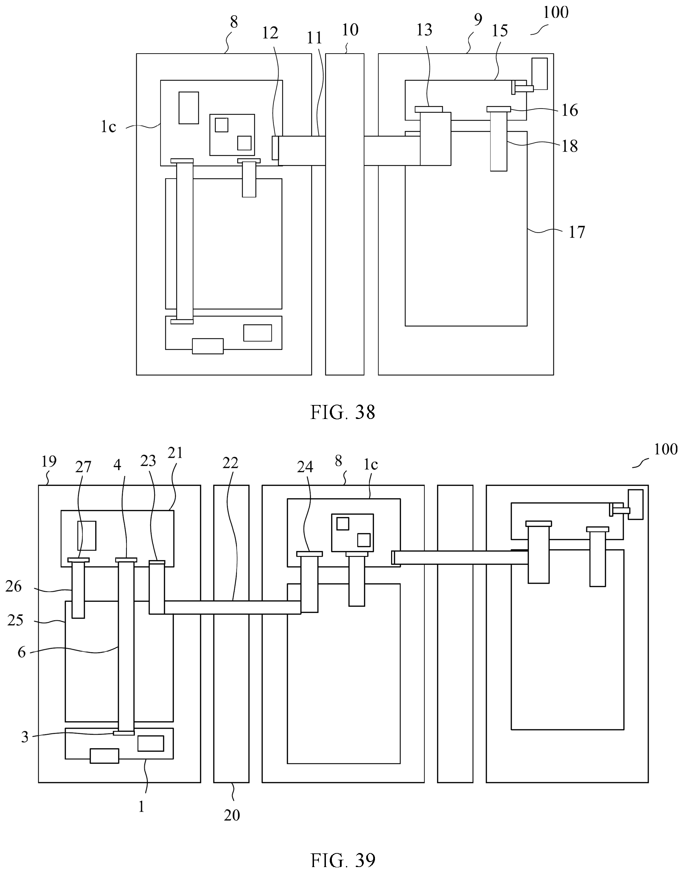

FIG. 38 is a schematic diagram of a charging scenario of an electronic device 100 (a dual-fold phone) in another embodiment. Different from the embodiment shown in FIG. 37, the electronic device 100 includes a first folding section 8, a second folding section 9, and a first rotating shaft 10, and the first folding section 8 and the second folding section 9 are rotatably connected by the first rotating shaft 10.

For the structure of the first folding section 8, refer to the embodiment shown in FIG. 37. The second folding section 9 is provided with a first hinge flexible circuit board 11, a fourth connector 12, a fifth connector 13, a first sub-mainboard 15, a sixth connector 16, a second battery 17, and a second battery flexible circuit board 18. One end of the first hinge flexible circuit board 11 passes through the first rotating shaft 10, and is electrically connected to the mainboard 1c by the fourth connector 12, and the other end of the first hinge flexible circuit board 11 is connected to the first sub-mainboard 15 by the fifth connector 13. One end of the second charging flexible circuit board 6 is electrically connected to the sub-mainboard 1c by the sixth connector 16, and the other end of the second charging flexible circuit board 6 is soldered to the second battery 17.

In this embodiment, and some structures connecting each flexible circuit board to a corresponding connector may have a bent shape. To improve the bent form of each flexible circuit board and reduce the risk of fracturing of each flexible circuit board, a matching height may be adjusted through the mutual cooperation of the electrical connection board and the recessed structure, so that the flexible circuit board has a proper bent form. For specific content, refer to the foregoing description, and details are not described herein again in this embodiment.

FIG. 39 is a schematic diagram of a charging scenario of an electronic device (a tri-fold phone) in another embodiment. Different from the embodiment shown in FIG. 38, the electronic device further includes a third folding section 19 and a second rotating shaft 20, and the third folding section 19 is rotatably connected to the first folding section 8 by the second rotating shaft 20.

A second sub-mainboard 21, a second hinge flexible circuit board 22, a seventh connector 23, an eighth connector 24, a third battery 25, a third battery flexible circuit board 26, and a ninth connector 27 are disposed on the third folding section 19. The sub-board 1 is located below the second sub-mainboard 21. One end of the charging flexible circuit board 6 is electrically connected to the sub-board 1 by the first connector 3, and the other end of the charging flexible circuit board 6 is connected to the second sub-mainboard 21 by the second connector 4. One end of the third hinge flexible circuit board 32 is electrically connected to the second sub-mainboard 21 by the seventh connector 23, and the other end of the third hinge flexible circuit board 32 passes through the second rotating shaft 20 and is electrically connected to the mainboard 1c by the eighth connector 24. One end of a flexible circuit of the third battery 25 is electrically connected to the second sub-mainboard 21 by the ninth connector 27, and the other end of the flexible circuit of the third battery 25 is soldered to the third battery 25. For the remaining structure, refer to the content of the embodiment shown in FIG. 38. Details are not described again in this embodiment.

In this embodiment, and some structures connecting each flexible circuit board to a corresponding connector may have a bent shape. To improve the bent form of each flexible circuit board and reduce the risk of fracturing of each flexible circuit board, a matching height may be adjusted through the mutual cooperation of the electrical connection board and the recessed mechanism, so that the flexible circuit board has a proper bent form. For specific content, refer to the foregoing description, and details are not described herein again in this embodiment.

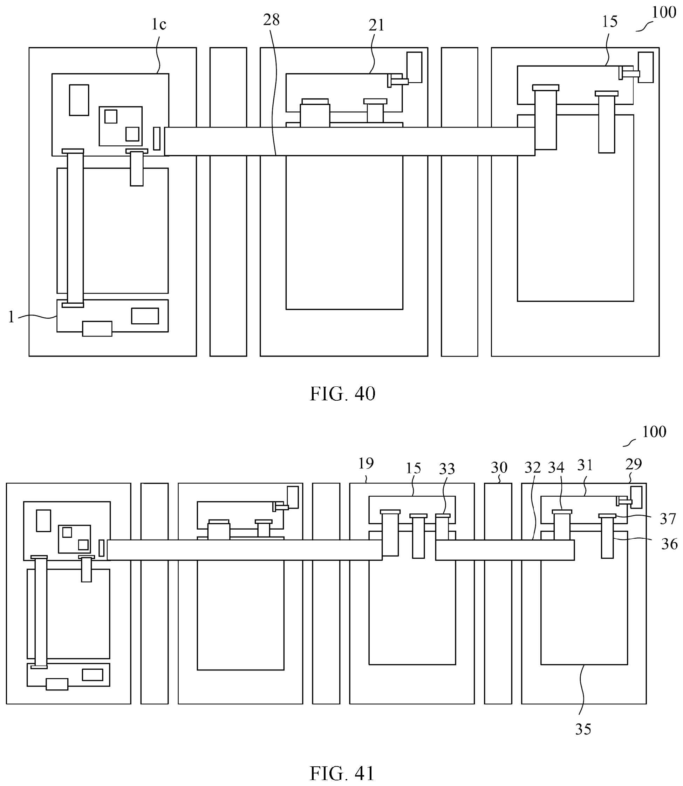

FIG. 40 is a schematic diagram of a charging scenario of an electronic device (a tri-fold phone) in another embodiment. Different from the embodiment shown in FIG. 39, the sub-board 1 is located below the mainboard 1c, the first hinge flexible circuit board 11 and the second hinge flexible circuit board 22 are omitted, and a three-way flexible circuit board 28 is used to electrically connect the mainboard 1c, the first sub-mainboard 15, and the second sub-mainboard 21. For the remaining structure, refer to the content of the embodiment shown in FIG. 39. Details are not described again in this embodiment.

In this embodiment, and some structures connecting each flexible circuit board to a corresponding connector may have a bent shape. To improve the bent form of each flexible circuit board and reduce the risk of fracturing of each flexible circuit board, a matching height may be adjusted through the mutual cooperation of the electrical connection board and the recessed mechanism, so that the flexible circuit board has a proper bent form. For specific content, refer to the foregoing description, and details are not described herein again in this embodiment.

FIG. 41 is a schematic diagram of a charging scenario of an electronic device (a quad-fold phone) in another embodiment. Different from the embodiment shown in FIG. 38, the electronic device further includes a fourth folding section 29 and a third rotating shaft 30, and the fourth folding section 29 is rotatably connected to the third folding section 19 by the third rotating shaft 30.

A third sub-mainboard 31, a third hinge flexible circuit board 32, a tenth connector 33, an eleventh connector 34, a fourth battery 35, a fourth battery flexible circuit board 36, and a twelfth connector 37 are disposed on the fourth folding section 29. One end of the third hinge flexible circuit board 32 passes through the third rotating shaft 30 and is electrically connected to the first sub-mainboard 15 by the tenth connector 33, and the other end of the third hinge flexible circuit board 32 is electrically connected to the third sub-mainboard 31 by the eleventh connector 34. One end of the fourth battery flexible circuit board 36 is electrically connected to the third sub-mainboard 31 by the twelfth connector 37, and the other end of the fourth battery flexible circuit board 36 is soldered to the fourth battery 35.

In this embodiment, and some structures connecting each flexible circuit board to a corresponding connector may have a bent shape. To improve the bent form of each flexible circuit board and reduce the risk of fracturing of each flexible circuit board, a matching height may be adjusted through the mutual cooperation of the electrical connection board and the recessed mechanism, so that the flexible circuit board has a proper bent form. For specific content, refer to the foregoing description, and details are not described herein again in this embodiment.

During actual application, in addition to the foregoing scenarios, the circuit board assembly may further be applied to another scenario in which a matching height needs to be adjusted, so that the flexible circuit board in the circuit board assembly has a proper bent form.

In addition, it should be noted that an example in which a flexible circuit board and a circuit board (for example, a mainboard) are connected by a connector is used for description above. In another embodiment, the second connection segment of the flexible circuit board may alternatively be connected to the circuit board in another manner. The connection manner includes, but is not limited to, soldering, connection through a conductive tape, crimp connection, and connection through magnetic attraction. It may be understood that when the second connection segment of the flexible circuit board is connected to the circuit board in a manner other than a connector, the distance between the second connection segment of the flexible circuit board and the circuit board may alternatively be adjusted in the foregoing manner of adding an electrical connection board or adding an electrical connection board and a recessed structure to the circuit board assembly, thereby adjusting the bent form of the flexible circuit board.

An example in which a flexible circuit board and an electrical connection board are connected by a connector is used for description above. In another embodiment, the flexible circuit board and the electrical connection board may alternatively be connected through soldering. Alternatively, the flexible circuit board and the electrical connection board may be connected through bonding. For the same or similar parts among all embodiments in the specification, refer to the relevant parts. Especially, an apparatus embodiment and a terminal embodiment are basically similar to a method embodiment, and therefore is described briefly.

The foregoing descriptions are only specific implementations of embodiments of this application, but are not intended to limit the scope of protection of the embodiments of this application. Any variation or replacement within the technical scope disclosed in the embodiments of this application shall fall within the scope of protection of the embodiments of this application. Therefore, the scope of protection of the embodiments of this application shall be subject to the scope of protection of the claims.

## Claims

1. A circuit board assembly, wherein the circuit board assembly comprises:
a circuit board;
an electrical connection board, wherein the electrical connection board is mounted on the circuit board in a thickness direction of the circuit board assembly, and is electrically connected to the circuit board; and
a flexible circuit board, wherein at least a part of the flexible circuit board has a flexible structure, the flexible circuit board comprises a first connection segment and a second connection segment, the first connection segment is configured to connect to a component of an electronic device, the second connection segment is connected to the electrical connection board, and the electrical connection board is configured to adjust a distance between the second connection segment and the circuit board in the thickness direction of the circuit board assembly.

2. The circuit board assembly according to claim 1, wherein the circuit board is provided with a recessed structure recessed in the thickness direction of the circuit board assembly; and
a partial structure of the electrical connection board is accommodated in the recessed structure, and the electrical connection board and the recessed structure are configured for adjusting the distance between the second connection segment and the circuit board in the thickness direction of the circuit board assembly.

3. The circuit board assembly according to claim 2, wherein the recessed structure comprises at least one groove.

4. The circuit board assembly according to claim 2, wherein the recessed structure comprises a first groove and a second groove that are spaced apart, and the circuit board is further provided with an element placement area located between the first groove and the second groove;
the electrical connection board comprises a first board, a second board, and a third board, a partial structure of the first board is accommodated in the first groove, a partial structure of the second board is accommodated in the second groove, the third board is disposed on the first board and the second board, and is electrically connected to the first board and the second board, and the third board is further electrically connected to the second connection segment; and
a gap exists between the third board and the element placement area in the thickness direction of the circuit board assembly.

5. The circuit board assembly according to claim 4, wherein when a depth of the first groove is greater than a thickness of the first board and a depth of the second groove is greater than a thickness of the second board, the third board is provided with a clearance groove for avoiding the element placement area.

6. The circuit board assembly according to claim 2, wherein the recessed structure is a through hole penetrating the circuit board in a thickness direction of the circuit board.

7. The circuit board assembly according to claim 6, wherein the recessed structure comprises a first hole, the electrical connection board comprises a first board and a second board, and the first board is connected to the circuit board and seals the first hole from a bottom; and
one end of the second board is connected to the first board, and the other end of the second board extends out of the through hole and is electrically connected to the second connection segment.

8. The circuit board assembly according to claim 6, wherein the recessed structure comprises a first hole and a second hole, and the circuit board is further provided with an element placement area located between the first hole and the second hole;
the electrical connection board comprises a first board, a second board, a third board, and a fourth board, the first board and the fourth board are distributed in the thickness direction of the circuit board assembly, and the second board and the third board are located between the first board and the fourth board and are connected to the first board and the fourth board; and
the first board is connected to the circuit board and seals the first hole and the second hole from a bottom, a partial structure of the second board is located in the first hole, a partial structure of the third board is located in the second hole, the fourth board is electrically connected to the second connection segment, and a gap exists between the fourth board and the element placement area in the thickness direction of the circuit board assembly.

9. The circuit board assembly according to any one of claims 1 to 8, wherein the electrical connection board is a PCB board; or
the electrical connection board comprises a conductive portion and a cladding portion, the conductive portion is located in the cladding portion, two ends of the conductive portion in the thickness direction of the circuit board assembly are exposed from the cladding portion, and the electrical connection board is electrically connected to the circuit board and the second connection segment by the conductive portion.

10. The circuit board assembly according to any one of claims 1 to 8, wherein the flexible circuit board comprises a deformation segment, and the deformation segment is located between the first connection segment and the second connection segment and is connected to the first connection segment and the second connection segment; and
the first connection segment and the second connection segment are rigid materials.

11. The circuit board assembly according to claim 10, wherein after the deformation segment is bent, a radius of an arc-shaped bend formed at an end of the deformation segment close to the first connection segment is a first radius R1, and a radius of an arc-shaped bend formed at an end of the deformation segment close to the second connection segment is a second radius R2; and
when R1 ≤ 0. 6 mm, and/or, R2 ≤ 0. 6 mm, a copper material in the flexible circuit board is HA copper.

12. The circuit board assembly according to claim 10, wherein a minimum distance between the first connection segment and the second connection segment is D1 ≥ 2 mm.

13. The circuit board assembly according to claim 10, wherein a minimum distance between a conductive hole in the first connection segment and the deformation segment is D2 > 0.5 mm; and
a minimum distance between a conductive hole in the second connection segment and the deformation segment is D2 > 0.5 mm.

14. The circuit board assembly according to claim 10, wherein a minimum distance between a circuit on the first connection segment and a connection position between the first connection segment and the deformation segment is D3 > 0.25 mm; and
a minimum distance between a circuit on the second connection segment and a connection position between the second connection segment and the deformation segment is D4 > 0.25 mm.

15. The circuit board assembly according to claim 10, wherein in an arrangement direction of the component of the electronic device and the electrical connection board, a ramp angle C of the flexible circuit board satisfies 0° ≤ C ≤ 80°.

16. An electronic device, wherein the electronic device comprises the circuit board assembly according to any one of claims 1 to 15.

17. The electronic device according to claim 16, wherein the electronic device comprises a mainboard and a camera module, the camera module comprises a lens, a lens holder, and a sensor, the sensor is connected to a bottom of the lens holder, the mainboard is a circuit board of the circuit board assembly, the first connection segment of the flexible circuit board is electrically connected to the sensor, and the second connection segment of the flexible circuit board is electrically connected to the electrical connection board by a connector.

18. The electronic device according to claim 16, wherein the electronic device comprises a mainboard, a charging module, and a sub-board, the charging module comprises a battery, the mainboard and the sub-board are circuit boards of the circuit board assembly, the first connection segment of the flexible circuit board is connected to the battery, and the second connection segment of the flexible circuit board is connected to the electrical connection board by a connector.

19. A circuit board assembly, wherein the circuit board assembly comprises:
a circuit board;
an electrical connection board, wherein the electrical connection board is mounted on the circuit board in a thickness direction of the circuit board assembly, and is electrically connected to the circuit board; and
a flexible circuit board, wherein at least a part of the flexible circuit board has a flexible structure, the flexible circuit board comprises a first connection segment and a second connection segment, the first connection segment is configured to connect to a component of an electronic device, the second connection segment is connected to the electrical connection board, and the electrical connection board is configured to adjust a distance between the second connection segment and the circuit board in the thickness direction of the circuit board assembly, wherein
the circuit board is provided with a recessed structure recessed in the thickness direction of the circuit board assembly; and
a partial structure of the electrical connection board is accommodated in the recessed structure, and the electrical connection board and the recessed structure are configured for adjusting the distance between the second connection segment and the circuit board in the thickness direction of the circuit board assembly.
